(19) Europäisches Patentamt / European Patent Office / Office européen des brevets

(11) **EP 3 163 897 B1**

(12) **EUROPEAN PATENT SPECIFICATION**

(45) Date of publication and mention
of the grant of the patent:
**04.12.2019 Bulletin 2019/49**

(51) Int Cl.:
***H04Q 9/00*** *(2006.01)*     ***G08C 19/00*** *(2006.01)*

(21) Application number: **14895548.7**

(22) Date of filing: **25.06.2014**

(86) International application number:
**PCT/JP2014/066859**

(87) International publication number:
**WO 2015/198425 (30.12.2015 Gazette 2015/52)**

(54) **BUILDING MANAGEMENT DEVICE, WIDE-AREA MANAGEMENT SYSTEM, DATA ACQUISITION METHOD, AND PROGRAM**

GEBÄUDEVERWALTUNGSVORRICHTUNG, GROSSFLÄCHIGES VERWALTUNGSSYSTEM, DATENERFASSUNGSVERFAHREN UND PROGRAMM

DISPOSITIF DE GESTION DE BÂTIMENT, SYSTÈME DE GESTION DE LARGE ZONE, PROCÉDÉ D'ACQUISITION DE DONNÉES ET PROGRAMME

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43) Date of publication of application:
**03.05.2017 Bulletin 2017/18**

(73) Proprietor: **Hitachi Systems, Ltd.**
**Tokyo 141-8672 (JP)**

(72) Inventors:
• **TOKUHASHI, Kazumasa**
**Tokyo 100-8280 (JP)**
• **OGATA, Yuji**
**Tokyo 100-8280 (JP)**

(74) Representative: **MERH-IP Matias Erny Reichl Hoffmann**
**Patentanwälte PartG mbB**
**Paul-Heyse-Strasse 29**
**80336 München (DE)**

(56) References cited:
CN-A- 102 869 079     JP-A- 2013 162 589
JP-A- 2013 162 589     JP-A- 2014 103 717
US-A1- 2003 125 890     US-A1- 2010 141 423
US-A1- 2014 139 188

**Description**

Technical Field

The present invention relates to a building management device, a wide area management system, a data acquiring method, and a program.

Background Art

It has been a common practice to install a management device for managing facility equipment in a building such as an office building, a hospital, a school, or a factory. There have also been systems for monitoring information of pieces of facility equipment in a plurality of buildings from a remote site via a communication line.

A known example of such systems is Energy Management Systems (EMSs), which manage energy that is consumed in a building such as electric power through an analysis of data collected from the building. EMSs that utilize big data are also known. Some EMSs are installed in a cloud to collect data from a building via an existing communication line and analyze the data.

There is described in Patent Literature 1 a way to prevent the worsening of network congestion and a load on a collection server from meter data, which is collected from a meter/gauge. The preventative includes: calculating a differential between the last-notified amount of change in meter value and the amount of change in meter value that is calculated from the last meter value and the current meter value; and transmitting meter data, which corresponds to the meter value, when the calculated differential exceeds a given threshold.

Citation List

Patent Literature

[PTL 1] Japanese Patent Laid-open Publication No. 2012-199726

In US 2014/139188 A1 a charge/discharge instruction apparatus is described. The apparatus includes a communicating unit, a communication frequency deciding unit and information collecting unit and a charge/discharge managing unit. The communication frequency deciding unit decides a collection frequency of information related to the battery storage system according to a state of the battery storage system.

In JP 2013/162589 A a method of measuring a change amount of a measured value of a measurement object at each supply of a supplier group that supplies the measurement object is described. A calculation device is provided for executing the estimation process.

Summary of Invention

Technical Problem

In a building, there are installed multiple sensors (for example, several thousand to several ten thousand sensors) such as a temperature sensor and an electric power sensor in order to manage the building. To manage power consumption, for example, a management device installed in the building needs to collect data from the multiple sensors. Those sensors are connected to, for example, a Field Area Network (FAN), and the management device collects data from those sensors via the FAN.

However, collecting data from the multiple sensors in the building frequently increases traffic in the FAN and adds to the load. In addition, building the system of a management device capable of handling a huge amount of information requires more cost. This is further compounded in the case of aggregating information of a plurality of buildings in a server in a cloud, where the number of sensors combined is immense, by causing congestion in communication lines between the buildings and the cloud and by running up the cost of building an EMS capable of handling a huge amount of information.

Communication traffic could be reduced by simply acquiring data from each of the multiple sensors less frequently. However, less frequent data acquisition leads to a drop in the precision of analysis of data such as power consumption.

Patent Literature 1 deals with a technology about meters/gauges that are installed in homes, and is not applicable to a management device that collects data from a plurality of sensors .

An object of the present invention is to prevent a drop in the precision of data analysis based on data that is collected from a plurality of sensors installed in a building, while reducing the traffic of a network to which the sensors are connected.

Solution to Problem

The invention of this application includes a plurality of means for attaining the object, an example of which is as follows :
There is provided a building management device to be installed in a building where a plurality of sensors are arranged, including: storage configured to store, for each of the plurality of sensors, an acquisition frequency indicating how often sensor information is acquired from the each of the plurality of sensors; a sensor information acquiring unit configured to acquire the sensor information from the each of the plurality of sensors at the acquisition frequency; a prediction unit configured to predict sensor information of one first sensor based on sensor information of a plurality of second sensors associated with the one first sensor, the one first sensor being a sensor that is high in acquisition frequency, the plurality of second sensors being sensors that are low in acquisition frequency; a comparison unit configured to compare the sensor information of the one first sensor and the predicted sensor information; and a frequency setting unit configured to set an acquisition frequency of at least one sensor out of the plurality of second sensors, based on a result of the comparison made by the comparison unit.

Advantageous Effects of Invention

According to the present invention, it is possible to prevent a drop in the precision of data analysis based on data that is collected from a plurality of sensors installed in a building, while reducing the traffic of a network to which the plurality of sensors are connected.

Other objects, configurations, and effects than those described above are revealed through a description of embodiments given below.

Brief Description of Drawings

FIG. 1 is a diagram for illustrating a configuration example of a wide area management system according to a first embodiment of the present invention.
FIG. 2 is a graph for showing transitions in power consumption that are observed when sensor information is acquired frequently.
FIG. 3 is a graph for showing transitions in power consumption that are observed when sensor information is acquired infrequently.
FIG. 4 is a diagram for illustrating a configuration example of a wide area management device.
FIG. 5 is a diagram for illustrating a configuration example of a building management device.
FIG. 6 is a diagram for showing a data structure example of a building management table.
FIG. 7 is a diagram for showing the data structure example of the building management table.
FIG. 8 is a diagram for showing a data structure example of an acquisition frequency determining policy.
FIG. 9 is a flow chart outlining the operation of the building management device.
FIG. 10 is a flow chart for illustrating an example of sensor information acquiring processing.
FIG. 11 is a flow chart for illustrating an example of comparison processing and prediction processing.
FIG. 12 is a flow chart for illustrating an example of acquisition frequency determining processing.
FIG. 13 is a diagram for illustrating a configuration example of a wide area management system according to a second embodiment of the present invention.
FIG. 14 is a diagram for showing another data structure example of the building management table.
FIG. 15 is a diagram for illustrating a configuration example of a wide area management system according to a third embodiment of the present invention.
FIG. 16 is a diagram for showing another data structure example of the building management table.
FIG. 17 is a diagram for illustrating a configuration example of hardware that implements the wide area management device and the building management device.

Description of Embodiments

<First Embodiment>

A first embodiment of the present invention is described with reference to the drawings.

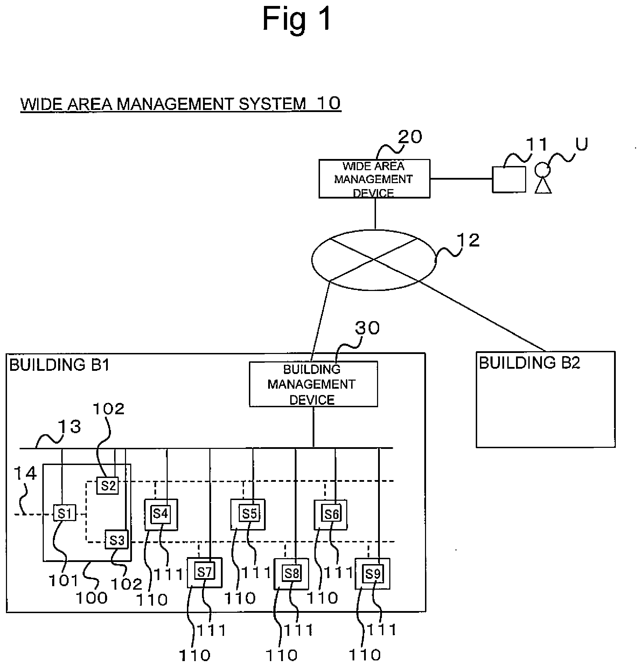

FIG. 1 is a diagram for illustrating a configuration example of a wide area management system according to the first embodiment of the present invention. A wide area management system 10 includes a wide area management device 20 and a building management device 30, which is installed in each of a plurality of buildings B (B1 and B2) (the building management device 30 in the building B2 is not shown in the drawing). The wide area management device 20 and each building management device 30 are connected to a communication line 12, which is a wide area network (WAN) such as the Internet, and are capable of transmitting and receiving communication data over the communication line 12.

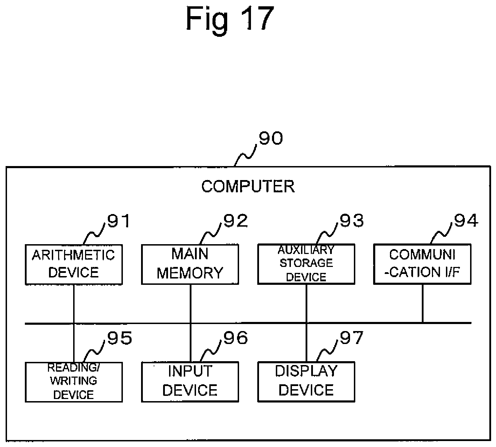

The wide area management device 20 receives commands for separately controlling the monitoring of power consumption and the like in the buildings B from an administrator U via an operation terminal 11 and an input device 96 (FIG. 17). The wide area management device 20 transmits the received commands to the building management devices 30 over the communication line 12.

The wide area management device 20 also receives information about power consumption and the like from each building management device 30 over the communication line 12 and records the received information. The wide area management device 20 displays information based on the recorded information about power consumption and the like on the operation terminal 11 or a display device 97 (FIG. 17) to show transitions in the power consumption and the like of the building to the administrator U.

In each building B, there is provided a communication line 13, which is a local area network (LAN) or the like. In the building B, there are also installed a distribution board 100 and a plurality of pieces of facility equipment 110. The distribution board 100 and the pieces of facility equipment 110 are connected to the communication line 13 to transmit/receive communication data to/from the building management device 30. A Field Area Network (FAN) is built from the communication line 13 in the building B.

Examples of the facility equipment 110 include air conditioning equipment, lighting equipment, boiler equipment, security equipment, and information technology (IT) equipment such as a server and a router, as well as monitoring equipment that monitors those pieces of equipment.

The distribution board 100 includes a host distribution board sensor 101 and subordinate distribution board sensors 102. Each piece of facility equipment 110 includes a device sensor 111. The host distribution board sensor 101 and the subordinate distribution board sensors 102 are, for example, sensors that measure the temperature of the distribution board 100, current sensors that measure a current flowing in the distribution board 100, voltage sensors that measure a voltage applied to the distribution board 100, or electric power sensors that measure the power consumption of the distribution board 100. The device sensor 111 is, for example, a sensor that measures the temperature of the facility equipment 110, a current sensor that measures a current flowing in the facility equipment 110, a voltage sensor that measures a voltage applied to the facility equipment 110, an electric power sensor that measures the power consumption of the facility equipment 110, or an infrared sensor that detects an object inside the building B. The sensors 101, 102, and 111 are not limited to the sensor types given above.

The following description takes as an example a case in which the host distribution board sensor 101, the subordinate distribution board sensors 102, and the device sensor 111 are electric power sensors, and the power consumption of the building B is monitored with those sensors.

The distribution board 100 branches a power line 14 led into the building B. The branched power line 14 is further branched to be connected to each piece of facility equipment 110. Electric power is fed to the distribution board 100 and each piece of facility equipment 110 in this manner. The host distribution board sensor 101, the subordinate distribution board sensors 102, and the device sensor 111 are also fed electric power.

The host distribution board sensor 101 is a sensor that is close to a power source (far from the device sensor 111), and the subordinate distribution board sensors 102 are sensors that are farther from the power source than the host distribution board sensor 101 is (close to the device sensor 111).

In FIG. 1, the host distribution board sensor 101 (S1) is installed in a section of the power line 14 that is led into the distribution board 100, and the subordinate distribution board sensor 102 (S2) and the subordinate distribution board sensor 102 (S3) are respectively installed in two branches of the power line 14. The branch of the power line 14 where the subordinate distribution board sensor 102 (S2) is installed is assigned three device sensors 111 (S4, S5, and S6). The branch of the power line 14 where the subordinate distribution board sensor 102 (S3) is installed is assigned three device sensors 111 (S7, S8, and S9).

The distribution board 100, which includes two layers of sensors, namely, the host distribution board sensor 101 and the subordinate distribution board sensors 102, in FIG. 1, may include three or more layers of sensors. In this case, the sensors of the respective layers may be defined as a primary host distribution board sensor, a secondary host distribution board sensor, ... an N-th order host distribution board sensor, and subordinate distribution board sensors in the order of proximity to the power source. In other words, the host distribution board sensors 101 constitute a plurality of layers, specifically, the first to N-th (N is a natural number equal to or more than 2) layers, and the subordinate distribution board sensors 102, which are closest to the device sensor 111, constitute a single layer. The device sensor 111 is a sensor one layer below the subordinate distribution board sensors 102.

When electric power sensors are arranged in the hierarchy described above, an electric power value that one electric power sensor registers can be acquired not only from the electric power sensor but also from estimation that sums up electric power values acquired from one or more electric power sensors that are one layer below the layer of the electric power sensor of interest and that are associated with the electric power sensor of interest (being associated with means being connected to a section of the power line 14 that is shared with the electric power sensor of interest). In the example of FIG. 1, the electric power values of the distribution board sensors (S1 to S3) have the following relations expressed by the electric power values of their associated device sensors one layer below (S4 to S9). The electric power values of the respective sensors are represented by S1 to S9.

$$S1 = S2 + S3$$

$$S2 = S4 + S5 + S6$$

$$S3 = S7 + S8 + S9$$

In this embodiment, predicted electric power values of the respective electric power sensors are calculated, details of which are described later. Also in this case, the predicted electric power values of the distribution board sensors (S1 to S3) have the following relations expressed by the predicted electric power values of their associated device sensors one layer below (S4 to S9). The predicted electric power values of the respective sensors are represented by S″1 to S″9.

$$S''1 = S''2 + S''3$$

$$S''2 = S''4 + S''5 + S''6$$

$$S''3 = S''7 + S''8 + S''9$$

The building management device 30 of each building B is connected to the communication line 13. The building management device 30 can transmit/receive communication data to/from the distribution board 100 and the pieces of facility equipment 110 over the communication line 13. In other words, the building management device 30 can hold communication to/from the sensors that are installed in the distribution board 100 and in the pieces of facility equipment 110.

The building management device 30 follows a command received from the wide area management device 20 in controlling the monitoring of the power consumption and the like of the building B. The building management device 30 acquires sensor information from the host distribution board sensor 101, the subordinate distribution board sensors 102, and each device sensor 111 via the communication line 13, at an acquisition frequency set for each sensor separately. The building management device 30 transmits the sensor information to the wide area management device 20 and changes the acquisition frequency, depending on the electric power value indicated by the acquired sensor information.

The sensor information corresponds to a measurement value (actually measured value) detected by a sensor, such as an electric power value detected by an electric power sensor.

The components of the wide area management system 10 in FIG. 1 are main components for illustrating the characteristics of the invention of this application, and the wide area management system 10 is not limited to the components described above. The illustrated configuration also does not exclude a configuration that general wide area management systems have. For example, the wide area management system 10 may include three or more buildings B. In this case also, each building B includes the building management device 30. The number of pieces of facility equipment 110 and the number of the device sensors 111 in each building B are not limited to those in the example of FIG. 1.

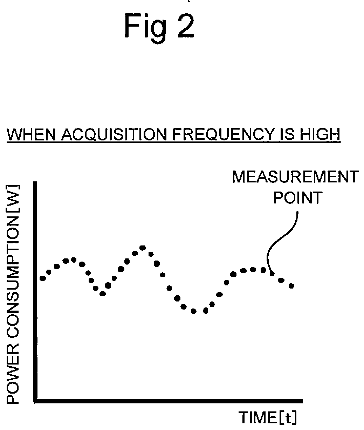

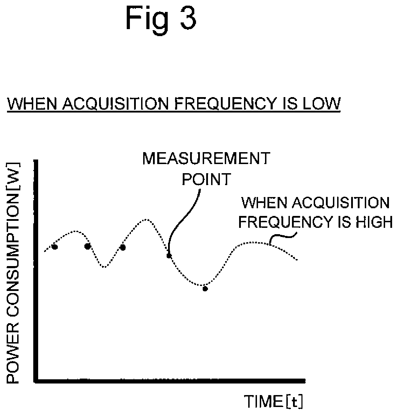

FIG. 2 is a graph for showing transitions in power consumption that are observed when the sensor information is acquired frequently. FIG. 3 is a graph for showing transitions in power consumption that are observed when the sensor information is acquired infrequently.

Transitions in power consumption based on an electric power value (measurement point) that is acquired frequently (for example, 100 packets per second (pps)) from one device sensor 111 are assumed to be as shown in FIG. 2. When an electric power value (measurement point) is acquired infrequently (for example, 10 pps) from this device sensor 111, on the other hand, transitions in power consumption based on the acquired electric power value are as shown in FIG. 3. In short, when the electric power value is acquired infrequently, the interval between measurement points is larger than when the electric power value is acquired frequently, and changes that should be measured in the interval do not emerge. Acquiring the electric power value less frequently reduces traffic in the FAN, but is adverse to precise measurement of changes in power consumption. The precision of data analysis drops accordingly.

The wide area management system 10 of this embodiment therefore has a configuration for measuring changes in power consumption with precision while reducing traffic in the FAN. A specific description is given below.

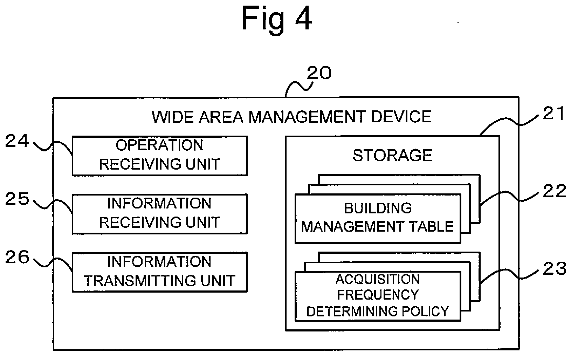

FIG. 4 is a diagram for illustrating a configuration example of the wide area management device . The wide area management device 20 includes storage 21, an operation receiving unit 24, an information receiving unit 25, and an information transmitting unit 26.

The storage 21 stores a building management table 22 for each building B. The storage 21 also stores an acquisition frequency determining policy 23 for each building B. The building management table 22 and the acquisition frequency determining policy 23 are described later when a description is given on a building management table 32 and an acquisition frequency determining policy 33.

The operation receiving unit 24, for example, receives, for each building management device 30, settings of the building management table 22, settings of the acquisition frequency determining policy 23, and other settings related to the building management device 30 from the administrator U via the operation terminal 11 and the input device 96 (FIG. 17), and stores the settings in the storage 21.

The information receiving unit 25, for example, receives, from each building management device 30, over the communication line 12, the sensor information that the building management device 30 collects from sensors installed in its building B. The information receiving unit 25 stores the received sensor information in the building management table 22 that is associated with this building B.

The information transmitting module 26, for example, reads, for each building management device 30, settings of the building management table 22, settings of the acquisition frequency determining policy 23, and other settings related to the building management device 30 out of the storage 21, and transmits the settings to the building management device 30 over the communication line 12.

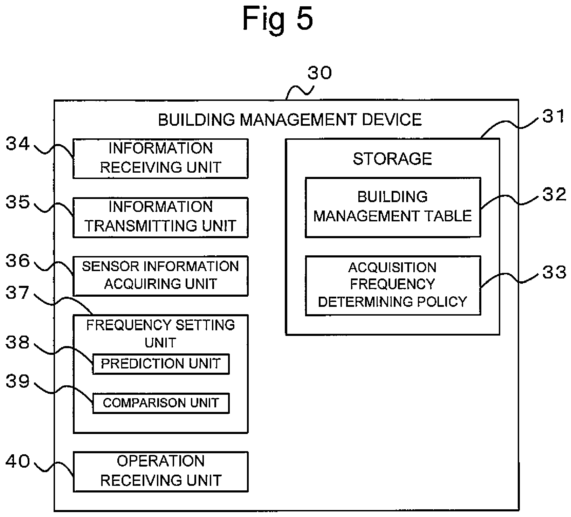

FIG. 5 is a diagram for illustrating a configuration example of the building management device. The building management device 30 includes storage 31, an information receiving unit 34, an information transmitting unit 35, a sensor information acquiring unit 36, a frequency setting unit 37, and an operation receiving unit 40.

The storage 31 stores a building management table 32 and an acquisition frequency determining policy 33.

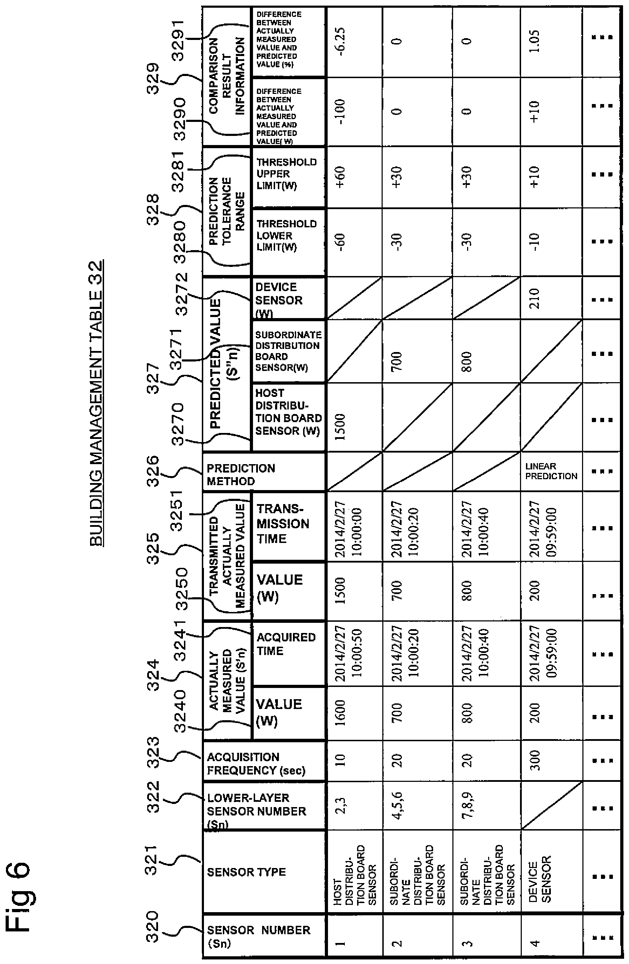

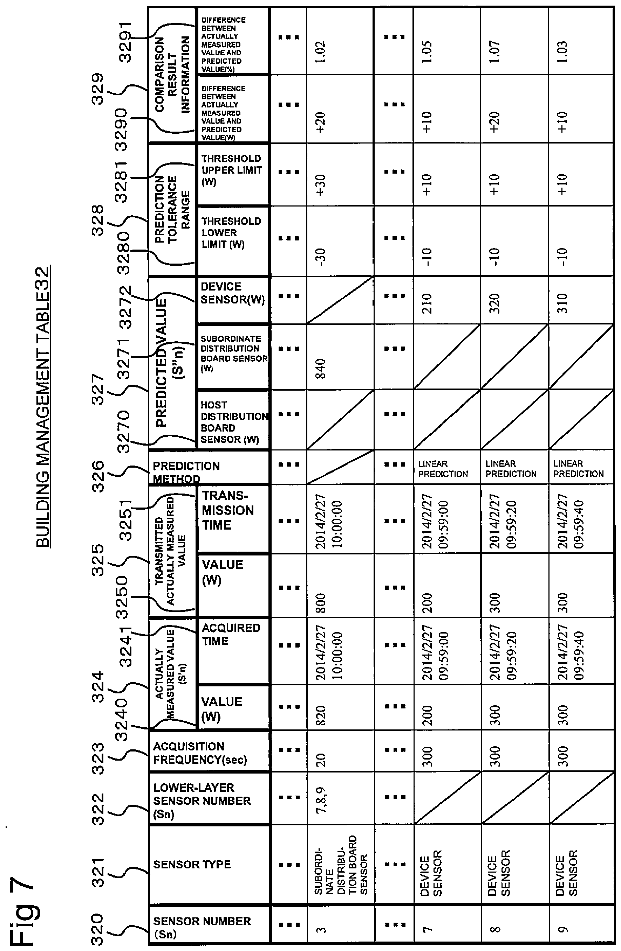

Information about sensors installed in the building B, actually measured values that are acquired from the sensors, and the like are stored in the building management table 32. Specifically, the building management table 32 holds, for each sensor, a sensor number 320, a sensor type 321, a lower-layer sensor number 322, an acquisition frequency 323, an actually measured value 324 (a value 3240 and an acquired time 3241), a transmitted actually measured value 325 (a value 3250 and a transmission time 3251), a prediction method 326, a predicted value 327 (a host distribution board sensor predicted value 3270, a subordinate distribution board sensor predicted value 3271, and a device sensor predicted value 3272), a prediction tolerance range 328 (a threshold lower limit 3280 and a threshold upper limit 3281), and comparison result information 329 (a differential value 3290 and a differential value 3291) in association with one another, as shown in FIG. 6 and FIG. 7 (which are diagrams for showing a data structure example of the building management table).

Data in the building management table 32 of FIG. 6 and FIG. 7 is of a case where the sensors (S1 to S9) are arranged as illustrated in FIG. 1.

The sensor number 320 is information for identifying a sensor which is referred to as sensor number Sn in this embodiment. The sensor type 321 is information that indicates the type of the sensor indicated by the sensor number 320. Values of the sensor type 321 here are "host distribution board sensor", "subordinate distribution board sensor", and "device sensor".

The lower-layer sensor number 322 is the sensor number of a sensor that is one layer below the sensor indicated by the sensor number 320. A plurality of sensor numbers can be stored as the lower-layer sensor number 322. For example, the sensor numbers of the subordinate distribution board sensors 102 that are associated with the host distribution board sensor 101 are included as the lower-layer sensor number 322 of the host distribution board sensor 101. The sensor numbers of the device sensors 111 that are associated with one subordinate distribution board sensor 102 are included as the lower-layer sensor number 322 of the subordinate distribution board sensor 102.

The acquisition frequency 323 is information that indicates how often sensor information is acquired from the sensor indicated by the sensor number 320, and is expressed in seconds in this embodiment. For example, an acquisition frequency"10" means that the sensor information is acquired once in ten seconds.

The actually measured value 324 is an actually measured value that is indicated by the sensor information acquired from the sensor of the sensor number 320, and includes the value 3240 and the acquired time 3241. A plurality of actually measured values acquired can be stored as the actually measured value 324 in this embodiment.

The transmitted actually measured value 325 is an actually measured value that has been transmitted to the wide area management device 20 out of actually measured values that are indicated by sensor information acquired from the sensor of the sensor number 320, and includes the value 3250 and the transmission time 3251. A plurality of actually measured values transmitted can be stored as the transmitted actually measured value 325 in this embodiment.

The prediction method 326 is information that indicates a method of predicting the value of sensor information that the sensor indicated by the sensor number 320 acquires. In this embodiment, a prediction method is set when the sensor type 321 is "device sensor", and no prediction method is set when the sensor type 321 indicates a distribution board sensor.

The predicted value 327 is a sensor information value that is predicted for the sensor indicated by the sensor number 320. The predicted value 327 in this embodiment can be stored for each sensor type separately, as the host distribution board sensor predicted value 3270, the subordinate distribution board sensor predicted value 3271, and the device sensor predicted value 3272.

The prediction tolerance range 328 is information that indicates the range of thresholds for making a determination about the differential between an actually measured value and predicted value of sensor information of the sensor indicated by the sensor number 320, and includes the threshold lower limit 3280 and the threshold upper limit 3281.

The comparison result information 329 is the differential between an actually measured value and predicted value of sensor information of the sensor indicated by the sensor number 320, and includes the differential value 3290, which indicates this differential, and the differential value 3291, which expresses this differential in the form of the ratio to the predicted value.

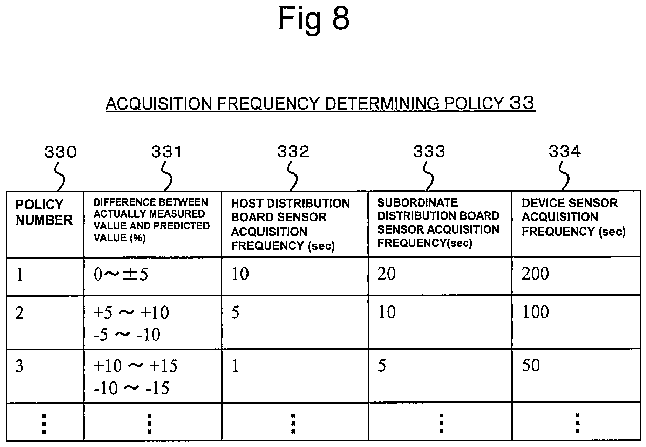

The acquisition frequency determining policy 33 holds rules (policies) that are applied when the acquisition frequencies of the respective sensors installed in the building B are changed. Specifically, each policy stored in the acquisition frequency determining policy 33 associates a policy number 330, a differential value 331, a host distribution board sensor acquisition frequency 332, a subordinate distribution board sensor acquisition policy 333, and a device sensor acquisition frequency 334 with one another, as shown in FIG. 8 (a diagram for showing a data structure example of the acquisition frequency determining policy).

The policy number 330 is information for identifying a policy. The differential value 331 indicates the differential between an actually measured value and predicted value of sensor information, and is the value of the differential expressed in the form of a ratio to the predicted value. Information indicating the range of the ratio is set here as the differential value 331. The host distribution board sensor acquisition frequency 332, the subordinate distribution board sensor acquisition frequency 333, and the device sensor acquisition frequency 334 are information that indicates changed acquisition frequencies (acquisition frequencies used after the policy is applied) of the respective sensors.

Referring back to FIG. 5, the information receiving unit 34, for example, receives settings of the building management table 32, settings of the acquisition frequency determining policy 33, and other settings related to the building management device 30 over the communication line 12, and stores the settings in the storage 31.

The information transmitting unit 35, for example, transmits sensor information acquired from the respective sensors to the wide area management device 20 over the communication line 12.

The sensor information acquiring unit 36, for example, acquires sensor information from the respective sensors (the host distribution board sensor 101, the subordinate distribution board sensors 102, and the device sensors 111) via the communication line 13, and stores the sensor information in the building management table 32. The sensor information acquiring unit 36 acquires sensor information from the respective sensors at frequencies that are indicated by the acquisition frequency 323 set in the building management table 32. How the sensor information is acquired is not particularly limited. For example, the sensor information acquiring unit 36 transmits a request for sensor information (a command to acquire sensor information) to a sensor and receives the sensor information in response. Details of the sensor information acquiring unit 36 are described later.

The frequency setting unit 37, for example, executes prediction processing in which a predicted value of sensor information is calculated from an actually measured value of the sensor information acquired by the sensor information acquiring unit 36. The frequency setting unit 37 also calculates, for example, the differential between the actually measured value and the predicted value. The frequency setting unit 37 also executes, for example, comparison processing for comparing the calculated differential against the prediction tolerance range 328 set in the building management table 32 and, when the calculated differential exceeds the tolerance range, transmits the actually measured value to the wide area management device 20. The frequency setting unit 37 also determines, for example, the acquisition frequencies of the respective sensors based on the calculated differential and the acquisition frequency determining policy 33, and sets the determined acquisition frequencies in the building management table 32. The frequency setting unit 37 includes a prediction unit 38 for executing the prediction processing described above, and a comparison unit 39 for executing the comparison processing described above. Details of the frequency setting unit 37, the prediction unit 38, and the comparison unit 39 are described later.

The operation receiving unit 40, for example, receives settings of the building management table 32, settings of the acquisition frequency determining policy 33, and other settings related to the building management device 30 from the administrator via an operation terminal (not shown) connected to the building management device 30 and the input device 96 (FIG. 17), and stores the settings in the storage 31.

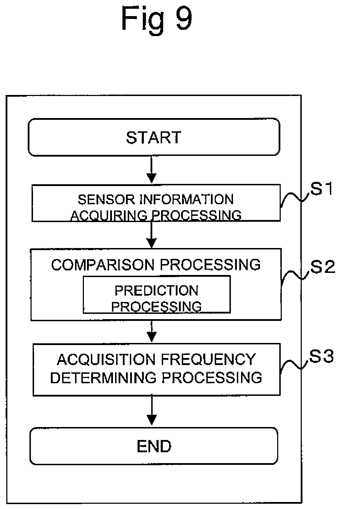

FIG. 9 is a flow chart outlining the operation of each building management device. The operation illustrated in the flow chart of FIG. 9 is executed repeatedly while, for example, the building management device 30 is powered on.

In preparation, the building management table 32 is stored in the storage 31. The values of at least the sensor number 320, the sensor type 321, the lower-layer sensor number 322, the acquisition frequency 323, the prediction method 326, and the prediction tolerance range 328 are set in advance out of the items of the building management table 32. The thus set building management table 32 is, for example, input by the administrator U to the wide area management device 20 via the operation terminal 11 and the input device 96 (FIG. 17), is transmitted from the wide area management device 20 to the building management device 30, and is stored in the storage 31. In another example, the building management table 32 is received by the operation receiving unit 40 from the administrator via the operation terminal 11 and the input device 96 (FIG. 17) to be stored in the storage 31.

Accordingly, the sensor number 320, the sensor type 321, the lower-layer sensor number 322, the acquisition frequency 323, the prediction method 326, and the prediction tolerance range 328 are set for each sensor installed in the building B as initial values in the building management table 32.

The acquisition frequency determining policy 33 is also stored in the storage 31 in preparation. Values are set in advance to all items of the acquisition frequency determining policy 33. The thus set acquisition frequency determining policy 33 is, for example, input by the administrator U to the wide area management device 20 via the operation terminal 11 and the input device 96 (FIG. 17), is transmitted from the wide area management device 20 to the building management device 30, and is stored in the storage 31. In another example, the acquisition frequency determining policy 33 is received by the operation receiving unit 40 from the administrator via the operation terminal (not shown) and the input device 96 (FIG. 17) to be stored in the storage 31.

The acquisition frequencies 323 of the respective sensors in the building management table 32 and the acquisition frequencies 332 to 334 of the respective sensors in the acquisition frequency determining policy 33 are set to values that satisfy the following relations in accordance with the hierarchy of the electric power sensors described above. In the case of a three-layer hierarchy that includes a host distribution board sensor, subordinate distribution board sensors, and device sensors, the acquisition frequencies of the sensors of the respective layers are represented by a, b, and c from the top layer downward. In the case of a hierarchy with four or more layers that include the primary to N-th order host distribution board sensors, subordinate distribution board sensors, and device sensors, the acquisition frequencies of the sensors of the respective layers are represented by a1, a2, ... aN, b, and c from the top layer downward.

- $a>b>c$
- $a1>a2>...>aN>b>c$

Setting a lower acquisition frequency for sensors in a lower layer the number of which is higher than the number of sensors in an upper layer in this manner reduces the traffic flow in the communication line 13. In addition, with the acquisition frequency set higher for sensors in an upper layer the number of which is small, the actually measured values of the sensors in the upper layer are acquired more frequently and changes in the values of a sensor group in a lower layer can be detected with higher precision. This is because changes in the actually measured value of an upper-layer sensor indicate changes in the sum of the values of a lower-layer sensor group that is associated with the upper-layer sensor.

Policies in the acquisition frequency determining policy 33 are set so that the acquisition frequencies 332 to 334 are lower when the differential value 331 between an actually measured value and a predicted value is smaller (when the differential value is closer to a reference value, which is a differential of 0). This ensures less traffic by setting a low acquisition frequency when the electric power value changes gradually and more precise detection of changes in electric power value by setting a high acquisition frequency when the electric power value changes rapidly.

Referring back to FIG. 9, sensor information acquiring processing (Step S1) is executed first by the sensor information acquiring unit 36. Subsequently, the frequency setting unit 37 executes the comparison processing and the prediction processing (Step S2). The frequency setting unit 37 then executes acquisition frequency determining processing (Step S3). After that, the processing illustrated in the flow chart of FIG. 9 is ended.

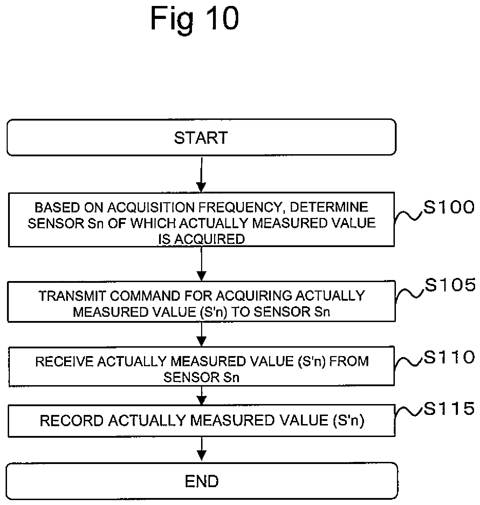

FIG. 10 is a flow chart for illustrating an example of the sensor information acquiring processing. FIG. 10 details the processing of Step S1 in FIG. 9.

The sensor information acquiring unit 36 first determines a sensor Sn of which an actually measured value is to be acquired, based on the acquisition frequency (Step S100). Specifically, the sensor information acquiring unit 36 monitors each sensor set in the building management table 32 for the recurring lapse of time that is indicated by the acquisition frequency 323 for a duration in which the operation of the flow chart of FIG. 9 is repeated, for example, with the use of a timer or the like. The sensor information acquiring unit 36 determines the sensor Sn for which the time indicated by the acquisition frequency 323 has elapsed as the sensor Sn of which an actually measured value is to be acquired. In this case, one sensor Sn is determined.

The sensor information acquiring unit 36 transmits a command for acquiring an actually measured value S'n to the sensor Sn determined in Step S100 (Step S105). The sensor Sn receives the acquisition command over the communication line 13, detects the electric power value, and transmits the detected value as the actually measured value S'n to the building management device 30. The sensor information acquiring unit 36 receives the actually measured value S'n transmitted from the sensor Sn (Step S110).

The sensor information acquiring unit 36 records the actually measured value S'n received in Step S110 (Step S115). Specifically, the sensor information acquiring unit 36 refers to the building management table 32 to store the received actually measured value S'n and the time of reception of the actually measured value S'n as the value 3240 and acquired time 3241 of the actually measured value 324 of the sensor Sn. The specifics of the time of reception of the actually measured value S'n are not particularly limited. The reception time may be, for example, a time at which a packet that contains the actually measured value is received from the sensor Sn, or time information contained in the packet that contains the actually measured value. The value of the reception time is also not limited to a particular format, and may be, for example, absolute time such as "2014/2/27 10:00:50", or relative time elapsed since a reference time that can be reset. The sensor information acquiring unit 36 then ends the processing illustrated in the flow chart of FIG. 10.

In this manner, actually measured values that are sensor information of the respective sensors are acquired at acquisition frequencies set for the respective sensors and stored in the building management table 32.

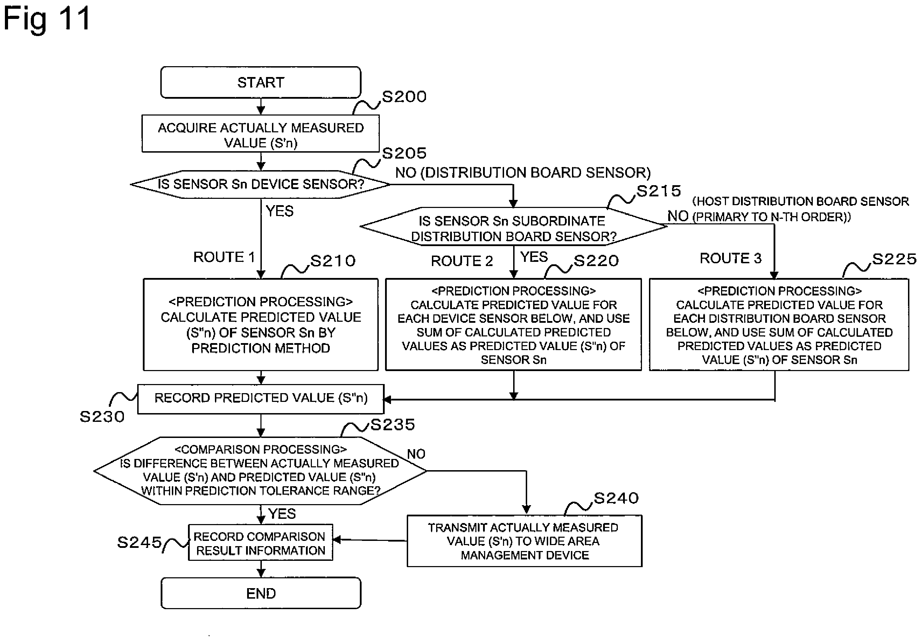

FIG. 11 is a flow chart for illustrating an example of the comparison processing and the prediction processing. FIG. 11 details the processing of Step S2 in FIG. 9. The processing of the flow chart of FIG. 11 is executed for one sensor Sn whose sensor information has been acquired in the processing of the flow chart of FIG. 10.

First, the frequency setting unit 37 acquires the actually measured value S'n (Step S200). Specifically, the frequency setting unit 37 refers to the building management table 32 to acquire the actually measured value S'n of the sensor Sn that has been recorded in Step S115 of FIG. 10.

The frequency setting unit 37 then determines whether or not the sensor Sn is one of the device sensors 111 (Step S205). Specifically, the frequency setting unit 37 refers to the building management table 32 to determine whether or not the sensor type 321 of the sensor Sn indicates a device sensor.

When the sensor Sn is one of the device sensors 111 (YES in Step S205), the frequency setting unit 37 executes prediction processing related to device sensors (Step S210). Specifically, the prediction unit 38 refers to the building management table 32 to identify the prediction method 326 of the sensor Sn. Based on the identified prediction method, the prediction unit 38 calculates a predicted value S"n of the sensor Sn. "Linear prediction", for example, is set as a prediction method for device sensors. The prediction unit 38 in this case refers to the building management table 32 to acquire at least two values 3250 out of values registered as the transmitted actually measured value 325 of the sensor Sn, and calculates the predicted value S"n by linear prediction from the acquired values 3250.

When the sensor Sn is not one of the device sensors 111 (NO in Step S205: when the sensor Sn is a distribution board sensor), the frequency setting unit 37 determines whether or not the sensor Sn is one of the subordinate distribution board sensors 102 (Step S215). Specifically, the frequency setting unit 37 refers to the building management table 32 to determine whether or not the sensor type 321 of the sensor Sn indicates a subordinate distribution board sensor.

When the sensor Sn is one of the subordinate distribution board sensors 102 (YES in Step S215), the frequency setting unit 37 executes prediction processing related to subordinate distribution board sensors (Step S220). Specifically, the prediction unit 38 refers to the building management table 32 to identify a lower-layer sensor number that is indicated by the lower-layer sensor number 322 of the sensor Sn. The prediction unit 38 refers again to the building management table 32 to acquire, for each lower-layer sensor number identified, one value 3250 from the transmitted actually measured value 325 that is associated with the identified lower-layer sensor number, and adds up the acquired values 3250, to thereby calculate the predicted value S"n.

The prediction unit 38 may use other methods to calculate the predicted value S"n in Step S220. For example, the prediction unit 38 refers to the building management table 32 to identify the prediction method 326 for each lower-layer sensor number that is identified in the manner described above. The prediction unit 38 calculates a predicted value by the identified prediction method for each lower-layer sensor number identified. The predicted value is calculated by the prediction method in the manner described above . The prediction unit 38 adds up the predicted values calculated for the respective lower-layer sensor numbers, thereby calculating the predicted value S"n. This way, an even more precise predicted value is acquired.

In another example of the calculation method, linear prediction, for example, is set to the prediction method 326 for distribution board sensors as well. The prediction unit 38 in this case refers to the building management table 32 to acquire at least two values 3250 out of values registered as the transmitted actually measured value 325 of the sensor Sn, and calculates the predicted value S"n by linear prediction from the acquired values 3250. The prediction method 326 is not limited to linear prediction.

When the sensor Sn is not one of the subordinate distribution board sensors 102 (NO in Step S215: when the sensor Sn is a host distribution board sensor (one of the primary to N-th order host distribution board sensors)), the frequency setting unit 37 executes prediction processing related to host distribution board sensors (Step S225). Specifically, the prediction unit 38 refers to the building management table 32 to identify a lower-layer sensor number that is indicated by the lower-layer sensor number 322 of the sensor Sn. The prediction unit 38 refers again to the building management table 32 to acquire, for each lower-layer sensor number identified, one value 3250 from the transmitted actually measured value 325 that is associated with the identified lower-layer sensor number, and adds up the acquired values 3250, to thereby calculate the predicted value S"n.

As in Step S220, the prediction unit 38 may use other methods to calculate the predicted value S"n in Step S225. For example, the prediction .unit 38 refers to the building management table 32 to identify a lower-layer sensor number (a subordinate distribution board sensor) that is indicated by the lower-layer sensor number 322 of the sensor Sn, and further identifies, for each lower-layer sensor number identified, a lower-layer sensor number (a device sensor) that is indicated by the lower-layer sensor number 322 of the subordinate distribution board sensor. The prediction unit 38 calculates a predicted value by a prediction -method for each identified device sensor, and adds up the calculated values to calculate the predicted value S"n. In another example, the prediction unit 38 acquires the transmitted actually measured value 325 for some subordinate distribution board sensors, while calculating, for the rest of subordinate distribution board sensors, predicted values of device sensors that are below the subordinate distribution board sensors, and adds up the acquired values and the calculated values. In other words, a combination of sensors in arbitrary layers can be selected from among sensors that are one or more layers below a host distribution board sensor. This selection method is set by, for example, the administrator.

The prediction unit 38 then records the predicted value S"n, which has been calculated in Step S210, Step S220, or Step S225 (Step S230). Specifically, the prediction unit 38 refers to the building management table 32 to store the calculated predicted value S"n as the predicted value 327 of the sensor Sn. In the case where the sensor Sn is a device sensor, the prediction unit 38 sets the calculated predicted value S"n to the predicted value 3272 of the device sensor. In the case where the sensor Sn is a subordinate distribution board sensor, the prediction unit 38 sets the calculated predicted value S"n to the predicted value 3271 of the subordinate distribution board sensor. In the case where the sensor Sn is a host distribution board sensor, the prediction unit 38 sets the calculated predicted value S"n to the predicted value 3270 of the host distribution board sensor.

The frequency setting unit 37 then executes the comparison processing (Step S235). Specifically, the comparison unit 39 compares the actually measured value S'n, which has been acquired in Step S200, and the predicted value S"n, which has been calculated in Step S210, Step S220, or Step S225, to calculate a differential value. The comparison unit 39 refers to the building management table 32 to acquire the threshold lower limit 3280 and threshold upper limit 3281 of the prediction tolerance range 328 of the sensor Sn. The comparison unit 39 determines whether or not the calculated differential value is within the threshold lower limit 3280 and the threshold upper limit 3281.

When the calculated differential value is outside the prediction tolerance range (NO in Step S235), the information transmitting unit 35 transmits the actually measured value S'n acquired in Step S200 to the wide area management device 20 (Step S240). At this point, the information transmitting unit 35 refers to the building management table 32 to store the actually measured value S'n transmitted and the time of transmission of the actually measured value S'n as the value 3250 and transmission time 3251 of the transmitted actually measured value 325 of the sensor Sn. The specifics of the time of transmission of the actually measured value S'n are not particularly limited. The transmission time may be, for example, a time at which a packet that contains the actually measured value is transmitted, or time information contained in the packet that contains the actually measured value. The value of the transmission time is also not limited to a particular format, and may be, for example, absolute time such as "2014/2/27 10:00:50", or relative time elapsed since a reference time that can be reset.

When the calculated differential value is within the prediction tolerance range (YES in Step S235), or after Step S240, the comparison unit 39 records comparison result information (Step S245). Specifically, the comparison unit 39 refers to the building management table 32 to store the differential value acquired in Step S235 as the differential value 3290 of the comparison result information 329 of the sensor Sn. The comparison unit 39 acquires the ratio of the actually measured value S'n to the predicted value S"n based on the actually measured value S'n and the predicted value S"n that have been used in Step S235, and stores the ratio as the differential value 3291 of the comparison result information 329 of the sensor Sn. The comparison unit 39 then ends the processing of the flow chart of FIG. 11.

In this manner, a comparison is made in the case of a device sensor ("Route 1" in FIG. 11) between an actually measured value of the device sensor and a predicted value that is calculated based on past actually measured values of the device sensor. Detecting changes in the measurement value of the device sensor and determining the accuracy of a predicted value are thus accomplished.

In the case of a subordinate distribution board sensor ("Route 2" in FIG. 11), a comparison is made between an actually measured value of the subordinate distribution board sensor and a predicted value that is calculated based on past actually measured values of a device sensor group below the subordinate distribution board sensor. Detecting changes in the measurement values of the device sensor group below and determining the accuracy of a predicted value are thus accomplished irrespective of how often sensor information of the device sensor group below is acquired (despite a low acquisition frequency).

In the case of a host distribution board sensor ("Route 3" in FIG. 11), a comparison is made between an actually measured value of the host distribution board sensor and a predicted value that is calculated based on past actually measured values of a distribution board sensor group below the host distribution board sensor. Detecting changes in the measurement values of the distribution board sensor group below and determining the accuracy of a predicted value are thus accomplished irrespective of how often sensor information of the distribution board sensor group below is acquired (despite a low acquisition frequency). The past actually measured values of the distribution board sensor group below also reflect changes in the measurement values of a sensor (distribution board sensor or device sensor) group further below this lower-layer distribution board sensor. Accordingly, changes in the measurement values of the sensor group below can be detected irrespective of how often sensor information of the sensor group below is acquired (despite a low acquisition frequency). In addition, changes in the measurement values of the sensor group below can be detected in the unit of the lower-layer distribution board sensors.

In the example described above, the actually measured value S'n is transmitted to the wide area management device 20 when the differential value of a sensor is outside a prediction tolerance range set for the sensor. This reduces traffic in the communication line 12 and the load on the wide area management device 20. In addition, because a prediction tolerance range can be set on a sensor-by-sensor basis, flexible monitoring control can be accomplished by, for example, setting the prediction tolerance range of a sensor based on the layer to which the sensor belongs or the type of the sensor.

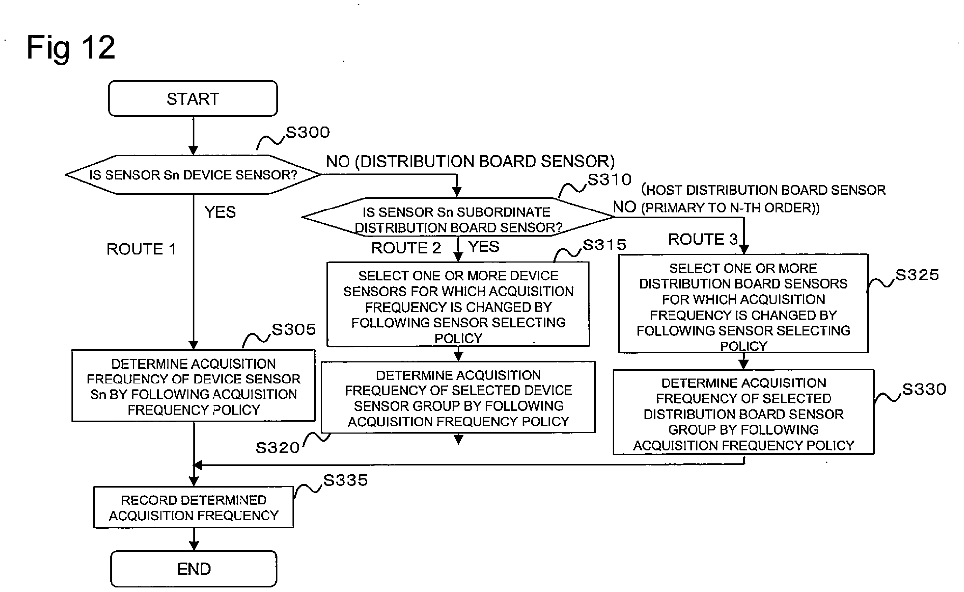

FIG. 12 is a flow chart for illustrating an example of the acquisition frequency determining processing. FIG. 12 details the processing of Step S3 in FIG. 9. The processing of the flow chart of FIG. 12 is executed for one sensor Sn whose sensor information has been acquired in the processing of the flow chart of FIG. 10.

First, the frequency setting unit 37 determines whether or not the sensor Sn is one of the device sensors 111 (Step S300). Specifically, the frequency setting unit 37 refers to the building management table 32 to determine whether or not the sensor type 321 of the sensor Sn indicates a device sensor.

When the sensor Sn is one of the device sensors 111 (YES in Step S300), the frequency setting unit 37 determines an acquisition frequency for the sensor Sn by following the acquisition frequency determining policy 33 (Step S305). Specifically, the frequency setting unit 37 refers to the building management table 32 to acquire the differential value 3291 of the comparison result information 329 of the sensor Sn. The frequency setting unit 37 refers to the acquisition frequency determining policy 33 to identify a policy in which the differential value 331 matches the acquired differential value 3291 (or includes the acquired differential value 3291) . The frequency setting unit 37 acquires the device sensor acquisition frequency 334 from the identified policy.

When the sensor Sn is not one of the device sensors 111 (NO in Step S300: when the sensor Sn is a distribution board sensor), the frequency setting unit 37 determines whether or not the sensor Sn is one of the subordinate distribution board sensors 102 (Step S310). Specifically, the frequency setting unit 37 refers to the building management table 32 to determine whether or not the sensor type 321 of the sensor Sn indicates a subordinate distribution board sensor.

When the sensor Sn is one of the subordinate distribution board sensors 102 (YES in Step S310), the frequency setting unit 37 selects one or more device sensors for which the acquisition frequency is to be changed, by following a given sensor selecting policy (Step S315). The sensor selecting policy is, for example, stored in advance in the storage 31 along with the acquisition frequency determining policy 33. For example, the sensor selecting policy is input by the administrator U to the wide area management device 20 via the operation terminal 11 and the input device 96 (FIG. 17), is transmitted from the wide area management device 20 to the building management device 30, and is stored in the storage 31. In another example, the sensor selecting policy is received by the operation receiving unit 40 from the administrator via the operation terminal (not shown) and the input device 96 (FIG. 17) to be stored in the storage 31.

A specific example of the sensor selecting policy is a policy in which a given number of lower-layer sensors are selected in descending order of the difference between an actually measured value and a predicted value. Another example is a policy in which a given number of lower-layer sensors are selected in chronological order of the time of transmission of the transmitted actually measured value. Here, the policy based on the difference between an actually measured value and a predicted value is used. The sensor selecting policy is not limited to the examples given above and, for example, the number of sensors selected may be set at the administrator's discretion, or may be determined by a given algorithm.

The frequency setting unit 37 refers to the building management table 32 to identify each lower-layer sensor number that is indicated by the lower-layer sensor number 322 of the sensor Sn. The frequency setting unit 37 sorts the identified lower-layer sensor numbers in descending order of the differential value 3291, and selects a given number of (two, for example) top lower-layer sensor numbers as the sensor numbers of device sensors for which the acquisition frequency is to be changed.

The frequency setting unit 37 determines the acquisition frequency of the device sensor group selected in Step S315 (Step S320). Specifically, the frequency setting unit 37 refers to the building management table 32 to acquire the differential value 3291 of the comparison result information 329 of the sensor Sn. The frequency setting unit 37 refers to the acquisition frequency determining policy 33 to identify a policy in which the differential value 331 matches the acquired differential value 3291 (or includes the acquired differential value 3291) . The frequency setting unit 37 acquires the device sensor acquisition frequency 334 and the subordinate distribution board sensor acquisition frequency 333 from the identified policy.

When the sensor Sn is not one of the subordinate distribution board sensors 102 (NO in Step S310: when the sensor Sn is a host distribution board sensor (one of the primary to N-th order host distribution board sensors)), the frequency setting unit 37 selects one or more distribution board sensors for which the acquisition frequency is to be changed, by following a given sensor selecting policy (Step S325). The sensor selecting policy is as described above. Here, the policy based on the difference between an actually measured value and a predicted value is used.

The frequency setting unit 37 refers to the building management table 32 to identify each lower-layer sensor number that is indicated by the lower-layer sensor number 322 of the sensor Sn. The frequency setting unit 37 sorts the identified lower-layer sensor numbers in descending order of the differential value 3291, and selects a given number of (two, for example) top lower-layer sensor numbers as the sensor numbers of distribution board sensors for which the acquisition frequency is to be changed.

The frequency setting unit 37 determines the acquisition frequency of the distribution board sensor group selected in Step S325 (Step S330) . Specifically, the frequency setting unit 37 refers to the building management table 32 to acquire the differential value 3291 of the comparison result information 329 of the sensor Sn. The frequency setting unit 37 refersto the acquisition frequency determining policy 33 to identify a policy in which the differential value 331 matches the acquired differential value 3291 (or includes the acquired differential value 3291) . The frequency setting unit 37 acquires the subordinate distribution board sensor acquisition frequency 333 and the host distribution board sensor acquisition frequency 332 from the identified policy.

The frequency setting unit 37 records the acquisition frequency determined in Step S305, Step S320, or Step S330 (Step S335). Specifically, the frequency setting unit 37 refers to the building management table 32 to store the determined acquisition frequency as the acquisition frequency 323. In the case where the sensor Sn is a device sensor, the frequency setting unit 37 sets the acquisition frequency determined for the sensor Sn to the acquisition frequency 323 of the sensor Sn. In the case where the sensor Sn is a subordinate distribution board sensor, the frequency setting unit 37 sets the acquisition frequency determined for the sensor Sn to the acquisition frequency 323 of the sensor Sn, and sets the acquisition frequency determined for the selected device sensors to the acquisition frequency 323 of each of the selected device sensors. In the case where the sensor Sn is a host distribution board sensor, the frequency setting unit 37 sets the acquisition frequency determined for the sensor Sn to the acquisition frequency 323 of the sensor Sn, and sets the acquisition frequency determined for the selected subordinate distribution board sensors to the acquisition frequency 323 of each of the selected subordinate distribution board sensors . The frequency setting unit 37 then ends the processing of the flow chart of FIG. 12.

When the sensor Sn is a subordinate distribution board sensor (YES in Step S310), the frequency setting unit 37 sets the acquisition frequency of the sensor Sn and the acquisition frequency of selected device sensors (Step S335) in the flow chart of FIG. 12. The frequency setting unit 37 may set in Step S335 the acquisition frequency of selected device sensors without setting the acquisition frequency (without changing the settings) of the sensor Sn. The frequency setting unit 37 in this case may choose to set, or not to set, the acquisition frequency of the sensor Sn depending on the differential value 3291 of the comparison result information 329 of the sensor Sn. For example, the frequency setting unit 37 sets only the acquisition frequency of the selected device sensors when the differential value 3291 is within a given range (when the differential is small), and sets the acquisition frequency of the sensor Sn and the acquisition frequency of the selected device sensors both when the differential value 3291 is outside the given range (when the differential is large).

When the sensor Sn is a host distribution board sensor (NO in Step S310), the frequency setting unit 37 sets the acquisition frequency of the sensor Sn and the acquisition frequency of the selected subordinate distribution board sensors (Step S335) in the flow chart of FIG. 12. The frequency setting unit 37 may also set in Step S335 the acquisition frequency of the selected device sensors . Specifically, in Step S325, the frequency setting unit 37 searches, for each selected lower-layer sensor number, the building management table 32 for an entry of the selected subordinate distribution board sensor to further identify a lower-layer sensor number that is indicated by the lower-layer sensor number 322 of the selected subordinate distribution board sensor. The frequency setting unit 37 selects, from among the identified lower-layer sensor numbers, the sensor numbers of device sensors for which the acquisition frequency is to be changed by following a sensor selecting policy. In Step S330, the frequency setting unit 37 acquires the device sensor acquisition frequency 334, the subordinate distribution board sensor acquisition frequency 333, and the host distribution board sensor acquisition frequency 332 from the identified policy. The frequency setting unit 37 may choose to set, or not to set, the acquisition frequency of the selected device sensors depending on the differential value 3291 of the comparison result information 329 of the sensor Sn. For example, the frequency setting unit 37 sets the acquisition frequency of the sensor Sn, the acquisition frequency of the selected subordinate distribution board sensors, and the acquisition frequency of the selected device sensors when the differential value 3291 is within a given range (when the differential is small), and sets the acquisition frequency of the sensor Sn and the acquisition frequency of the selected subordinate distribution board sensors when the differential value 3291 is outside the given range (when the differential is large) . In another example, the frequency setting unit 37 may set only the acquisition frequency of the selected device sensors when the differential value 3291 is within the given range (when the differential is small), without setting the acquisition frequencies (without changing the settings) of the sensor Sn and the selected subordinate distribution board sensors. Alternatively, the frequency setting unit 37 may set the acquisition frequencies of the selected subordinate distribution board sensors and the selected device sensors without setting the acquisition frequency (without changing the settings) of the sensor Sn.

In this manner, in the case where the sensor Sn is a device sensor ("Route 1" in FIG. 12), the acquisition frequency of the device sensor is changed depending on the result of a comparison between an actually measured value and a predicted value of the device sensor. Accordingly, when the difference between an actually measured value and a predicted value of a device sensor is small, for example, traffic can be reduced by decreasing the acquisition frequency of the device sensor, while detecting changes in the measurement values of the device sensor group with precision by maintaining the distribution board sensor acquisition frequency. When the difference between an actually measured value and a predicted value of a device sensor is large, for example, changes in the measurement value of the device sensor can be detected with precision by setting a high acquisition frequency to the device sensor.

In the case where the sensor Sn is a subordinate distribution board sensor ("Route 2" in FIG. 12), the acquisition frequency of the subordinate distribution board sensor and the acquisition frequency of the device sensor group below the subordinate distribution board sensor are changed depending on the result of a comparison between an actually measured value and a predicted value of the subordinate distribution board sensor. Accordingly, when the difference between an actually measured value and a predicted value of the subordinate distribution board sensor is small, for example, traffic can be reduced by decreasing the acquisition frequencies of the subordinate distribution board sensor and the device sensor group, while detecting changes in the measurement values of the lower-layer distribution board sensor group and the device sensor group with precision by maintaining the host distribution board sensor acquisition frequency. Because the number of subordinate distribution board sensors is smaller than the number of device sensors, when the difference between an actually measured value and a predicted value of the subordinate distribution board sensor is small, for example, changes in the measurement values of the device sensor group can be detected with precision while reducing traffic by maintaining, instead of changing, the acquisition frequencies of the host distribution board sensor and the subordinate distribution board sensor and lowering the acquisition frequency of the device sensor group. When the difference between an actually measured value and a predicted value of the subordinate distribution board sensor is large, for example, changes in the measurement values of the subordinate distribution board sensor and the device sensor group can be detected with precision by setting high acquisition frequencies to the subordinate distribution board sensor and the device sensor group. In addition, because the acquisition frequency is changed for a given number of device sensors selected by a selection policy, a rapid increase in traffic that is caused by, for example, setting a higher acquisition frequency is prevented.

In the case where the sensor Sn is a host distribution board sensor ("Route 3" in FIG. 12), the acquisition frequency of the host distribution board sensor and the acquisition frequencies of a group of distribution board sensors that are below the host distribution board sensor (a lower-layer distribution board sensor group) and of a device sensor group are changed depending on the result of a comparison between an actually measured value and a predicted value of the host distribution board sensor. Accordingly, when the difference between an actually measured value and a predicted value of the host distribution board sensor is small, for example, a decrease in traffic and correct detection of changes in the measurement values of the device sensor group at a distribution board sensor are accomplished by setting low acquisition frequencies to the host distribution board sensor, the lower-layer distribution board sensor group, and the device sensor group. Because the number of distribution board sensors is smaller than the number of device sensors, when the difference between an actually measured value and a predicted value of the host distribution board sensor is small, for example, changes in the measurement values of the device sensor group (or the lower-layer distribution board sensor group plus the device sensor group) can be detected with precision while reducing traffic by maintaining, instead of changing, the acquisition frequencies of the host distribution board sensor and the lower-layer distribution board sensor group (or the acquisition frequency of the host distribution board sensor alone) and lowering the acquisition frequency of the device sensor group (or the acquisition frequencies of the lower-layer distribution board sensor group and the device sensor group). When the difference between an actually measured value and a predicted value of the host distribution board sensor is large, for example, changes in the measurement values of the lower-layer distribution board sensor group and the device sensor group can be detected with precision by setting high acquisition frequencies to the host distribution board sensor and the lower-layer distribution board sensor group. This is because increasing the acquisition frequencies of the host distribution board sensor and a group of distribution board sensors below the host distribution board sensor results in more frequent search for a group of device sensors that are further below and that have undergone changes in value. In addition, because the acquisition frequency is changed for a given number of lower-layer distribution board sensors selected by a selection policy, a rapid increase in traffic that is caused by, for example, setting a higher acquisition frequency is prevented.

The first embodiment of the present invention has now been described. According to the first embodiment, the precision of data analysis based on data that is collected from a plurality of sensors installed in a building is prevented from dropping, while the traffic of a network to which the sensors are connected is reduced.

<Second Embodiment>

A second embodiment of the present invention is described below with reference to the drawings. The description centers on differences from the first embodiment. Components that are the same as those in the first embodiment are denoted by the same reference symbols, and descriptions thereof are omitted.

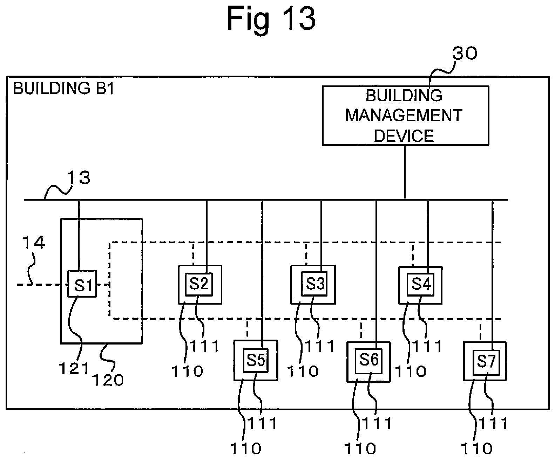

FIG. 13 is a diagram for illustrating a configuration example of a wide area management system according to the second embodiment of the present invention. The second embodiment differs from the first embodiment in distribution board configuration. A distribution board 120 is installed in the building B1.

The distribution board 120 branches the power line 14 led into the building B. The branched power line 14 is further branched to be connected to each piece of facility equipment 110. The distribution board 120 includes one layer of a distribution board sensor 121.

In the example of FIG. 13, the distribution board sensor 121 (S1) is installed in a section of the power line 14 that is led into the distribution board 120, three device sensors 111 (S2, S3, and S4) are installed in one of the two branches of the power line 14, and three device sensors 111 (S5, S6, and S7) are installed in the other branch.

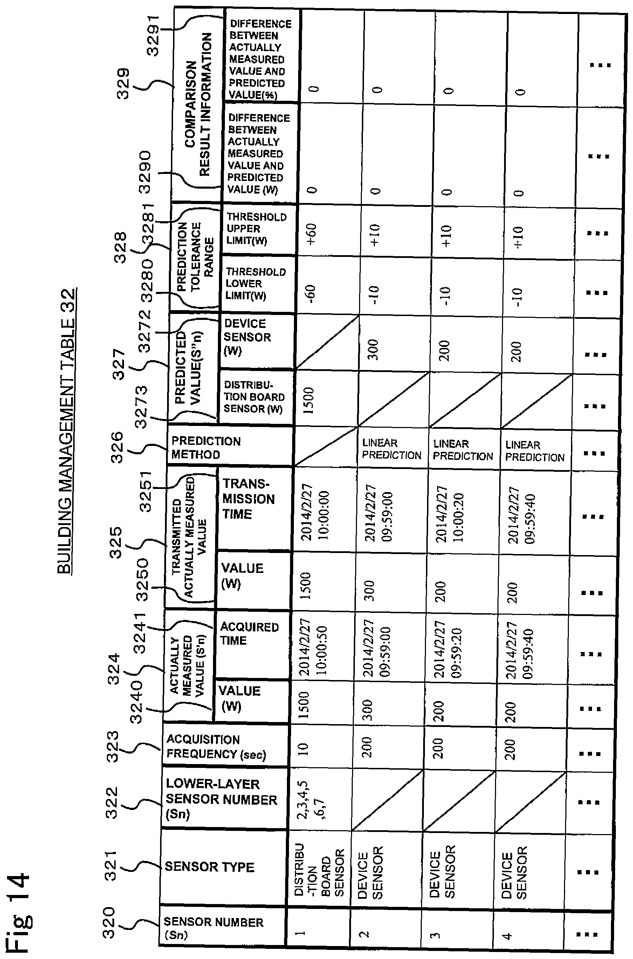

In the case of the hierarchy described above, the building management table 32 is as shown in FIG. 14 (a diagram for showing a data structure example of the building management table) . Differences from the first embodiment are as follows:

"Distribution board sensor" or "device sensor" is set as the sensor type 321. The predicted value 327 includes a predicted value 3273 of the distribution board sensor 121 and the predicted value 3272 of the device sensor 111.

The processing illustrated in the flow charts of FIG. 9 to FIG. 12 is similarly applicable to the second embodiment. The distribution board sensor 121 in the second embodiment can be handled as the subordinate distribution board sensors 102 in the first embodiment. In the second embodiment where the host distribution board sensor 101 is not included, steps in FIG. 11 and FIG. 12 that are for the case where the sensor Sn is the host distribution board sensor 101 (Route 3) are not executed.

The second embodiment of the present invention has now been described. The same effects as in the first embodiment are acquired also in the second embodiment.

<Third Embodiment>

A third embodiment of the present invention is described below with reference to the drawings. The description centers on differences from the first embodiment. Components that are the same as those in the first embodiment are denoted by the same reference symbols, and descriptions thereof are omitted.

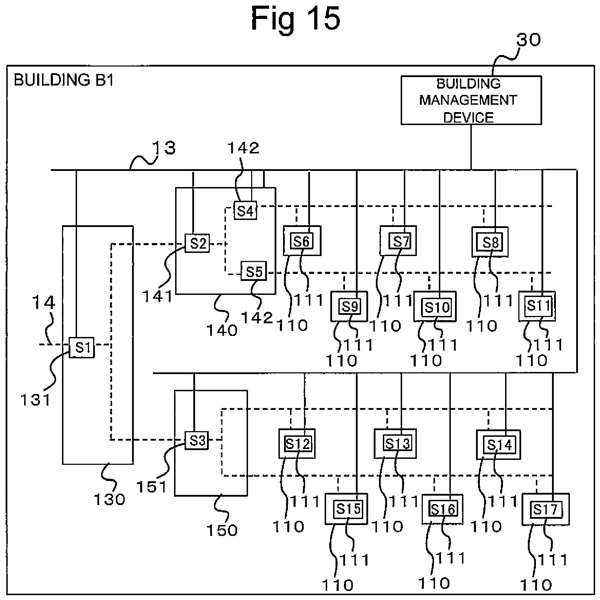

FIG. 15 is a diagram for illustrating a configuration example of a wide area management system according to the third embodiment of the present invention. The third embodiment differs from the first embodiment in distribution board configuration and power line configuration. In the building B1, there are installed a distribution board 130, a distribution board 140, and a distribution board 150. The distribution board 130 is closest to the power source .

The distribution board 130 branches a section of the power line 14 that is led into the building B into two branches, which are connected to the distribution board 140 and the distribution board 150, respectively. The branch of the power line 14 that is connected to the distribution board 140 is further branched to be connected to pieces of the facility equipment 110. The branch of the power line 14 that is connected to the distribution board 150 is further branched to be connected to pieces of the facility equipment 110.

The distribution board 130 includes a primary host distribution board sensor 131. The distribution board 140 includes a secondary host distribution board sensor 141 and subordinate distribution board sensors 142. The distribution board 150 includes a distribution board sensor 151, which corresponds to the subordinate distribution board sensors 142. In the case of a wide area management system that includes a plurality of distribution boards also, distribution board sensors can be managed in hierarchy by handling the plurality of distribution boards as a single distribution board.

In the example of FIG. 15, the primary host distribution board sensor 131 (S1) is installed in a section of the power line 14 that is led into the distribution board 130. The secondary host distribution board sensor 141 (S2) is installed in a section of the power line 14 that is led into the distribution board 140, and the subordinate distribution board sensor 142 (S4) and the subordinate distribution board sensor 142 (S5) are respectively installed in the two branches of this section of the power line 14. The branch of the power line 14 where the subordinate distribution board sensor 142 (S4) is installed is assigned three device sensors 111 (S6, S7, and S8). The branch of the power line 14, where the subordinate distribution board sensor 142 (S5) is installed, is assigned three device sensors 111 (S9, S10, and S11). Further, the distribution board sensor 151 (S3) is installed in a section of the power line 14 that is led into the distribution board 150, three device sensors 111 (S12, S13, and S14) are installed in one of the two branches of the power line 14, and three device sensors 111 (S15, S16, and S17) are installed in the other branch.

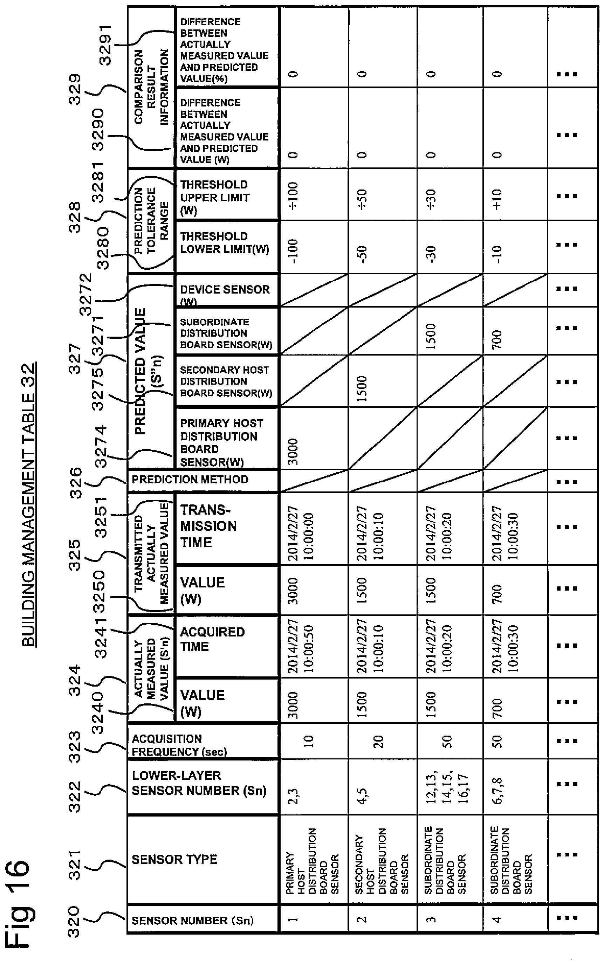

In the case of the hierarchy described above, the building management table 32 is as shown in FIG. 16 (a diagram for showing a data structure example of the building management table) . Differences from the first embodiment are as follows: "Primary host distribution board sensor", "secondary host distribution board sensor", "subordinate distribution board sensor", or"device sensor" is set as the sensor type 321. The predicted value 327 includes a predicted value 3274 of the primary host distribution board sensor 131, a predicted value 3275 of the secondary host distribution board sensor 141, the predicted value 3271 of the subordinate distribution board sensors 142, and the predicted value 3272 of the device sensors 111.

The processing illustrated in the flow charts of FIG. 9 to FIG. 12 is similarly applicable to the third embodiment. The distribution board sensor 151 in the third embodiment can be handled as the subordinate distribution board sensors 102 in the first embodiment. The primary host distribution board sensor 131 and the secondary host distribution board sensor 141 can be handled as the host distribution board sensor 101 in the first embodiment.

The third embodiment of the present invention has now been described. The same effects as in the first embodiment are acquired also in the third embodiment.

<Modification Example>

The present invention is not limited to the embodiments described above, and can be carried out in various modes without departing from the spirit of the present invention. For example, the following modifications can be made:

In the embodiments described above, the differential between an actually measured value and a predicted value is calculated as comparison result information (Step S235 of FIG. 11), and this comparison result information is used in the acquisition frequency determining processing (Step S305, Step S320, and Step S330 of FIG. 12). However, the comparison result information is not limited to the differential between an actually measured value and a predicted value, and can be other types of information.

For example, the comparison unit 39 accumulates, for each sensor number, the differential value between an actually measured value and a predicted value which is calculated in Step S235 in the storage 31 as history separate from the comparison result information 329 of the building management table 32. The comparison unit 39 calculates in Step S245 an average value (for example, moving average) of differential values based on the differential value of the sensor Sn acquired in Step S235 and the history of differential values of the sensor Sn accumulated in the storage 31. The comparison unit 39 stores the average value as the comparison result information 329 in the building management table 32. The present invention may also be modified so that the differential value is accumulated in the storage 31 in the case where an actually measured value is transmitted to the wide area management device 20 (NO in Step S235). The differential value accumulated in the storage 31 in this case is the differential between the transmitted actually measured value and a predicted value. In another example, the comparison unit 39 calculates in Step S245 the differential value between the differential value of the sensor Sn acquired in Step S235 and an average value (for example, moving average) of one or more differential values of the sensor Sn accumulated in the storage 31. The comparison unit 39 stores the calculated differential value as the comparison result information 329 in the building management table 32. A value suitable for the type of the comparison result information is set to the differential value 331 of the acquisition frequency determining policy 33 by the administrator or the like. The administrator may be allowed to select which type of comparison result information to use.

The wide area management device 20 and the building management device 30 in the embodiments and the modification example described above are each implemented by, for example, a computer 90 illustrated in FIG. 17 (a diagram for illustrating a configuration example of hardware that implements the wide area management device and the building management device).

The computer 90 includes, for example, an arithmetic device 91 such as a central processing unit (CPU), a main memory 92 such as a random access memory (RAM), an auxiliary storage device 93 such as a flash read-only memory (ROM) or a hard disk drive (HDD), a communication interface (I/F) 94, which is connected to a communication line, a reading/writing device 95, which reads and writes information on a portable storage medium such as a digital versatile disk (DVD), the input device 96 such as a keyboard and a mouse, and the display device 97 such as a liquid crystal display.

When the computer 90 functions as the wide area management device 20, the operation receiving unit 24, the information receiving unit 25, and the information transmitting unit 26 can be implemented by, for example, the arithmetic device 91 by loading a given program that is stored in the auxiliary storage device 93 onto the main memory 92 and executing the program. The storage 21 can be implemented by, for example, the main memory 92 or the auxiliary storage device 93. The storage 21 may also be implemented by, for example, storage in a communication network that is connected via the communication I/F 94. The communication function of the wide area management device 20 is implemented by, for example, the arithmetic device 91 by using the communication I/F 94.

The given program of the wide area management device 20 can be installed in the wide area management device 20 by, for example, storing the program on another server in the communication network in a manner that allows for the downloading of the program, or storing the program on a portable storage medium such as a DVD and distributing the storage medium.

When the computer 90 functions as the building management device 30, the information receiving unit 34, the information transmitting unit 35, the sensor information acquiring unit 36, the frequency setting unit 37, and the operation receiving unit 40 can be implemented by, for example, the arithmetic device 91 by loading a given program that is stored in the auxiliary storage device 93 onto the main memory 92 and executing the program. The storage 31 can be implemented by, for example, the main memory 92 or the auxiliary storage device 93. The storage 31 may also be implemented by, for example, storage in a communication network that is connected via the communication I/F 94. The communication function of the building management device 30 is implemented by, for example, the arithmetic device 91 by using the communication I/F 94.

The given program of the building management device 30 can be installed in the building management device 30 by, for example, storing the program on another server in the communication network in a manner that allows for the downloading of the program, or storing the program on a portable storage medium such as a DVD and distributing the storage medium.

The components of the wide area management device 20 shown in FIG. 4 and the components of the building management device 30 shown in FIG. 5 are classified based on the specifics of main processing for easy understanding of the configurations of the devices. The invention of this application is not limited by how the components are classified or named. The configurations of the wide area management device 20 and the building management device 30 can be broken into more components based on the specifics of the processing. The configurations may also be broken down so that a single component can execute more processing procedures. The processing of each component may be executed by a single piece of hardware, or by a plurality of pieces of hardware.

The processing units in the flow charts of FIG. 9 to FIG. 12 are divided based on the specifics of main processing for easy understanding of the processing of the building management device 30. The invention of this application is not limited by how the processing units are divided or named. The processing of the building management device 30 can be broken into more processing units based on the specifics of the processing. The processing may also be divided so that one processing unit includes more processing steps. The order of the processing units is also not limited to those shown in the drawings, as long as the object of the present invention is attained.

The present invention is not limited to the embodiments described above, and includes various modification examples. For instance, the embodiments are descriptions written in detail for easy understanding of the present invention, and the present invention is not necessarily limited to a mode that includes all of the components described. A part of the configuration of one embodiment may be replaced with the configuration of another embodiment, and the configuration of one embodiment may be added with the configuration of another embodiment. Further, another configuration may be added with or removed from, or may replace a part of the configuration of each embodiment.

Further, each of the above-mentioned parts, functions, processing units, processing means, and the like may be realized by hardware by designing and the like all or some of such parts, functions, processing units, and processing means as integrated circuits, for example. In addition, each of the above-mentioned parts, functions, and the like may also be realized by software by interpreting and executing programs for realizing each function with a processor. Information about the programs, tables, files, and the like for realizing each function may be stored in a memory, a storage device such as a hard disk and a solid state drive (SSD), or a recording medium such as an IC card, an SD card, and a DVD.

Further, only control lines and information lines thought to be necessary for explanation are illustrated. Not all of the control lines and information lines in a product are illustrated. In an actual product, it may be considered that almost all parts are connected to each other.

Lastly, the present invention is not limited to electric power sensors, and is applicable to various types of sensors that can be arranged in hierarchy.

Reference Signs List

| | |
|---|---|
| B, B1, B2: | building |
| U: | administrator |
| 10: | wide area management system |
| 11: | operation terminal |
| 12: | communication line |
| 13: | communication line |
| 14: | power line |
| 20: | wide area management device |
| 21: | storage |
| 22: | building management table |
| 23: | acquisition frequency determining policy |
| 24: | operation receiving unit |
| 25: | information receiving unit |
| 26: | information transmitting module |
| 30: | building management device |
| 31: | storage |
| 32: | building management table |
| 33: | acquisition frequency determining policy |
| 34: | information receiving unit |
| 35: | information transmitting unit |
| 36: | sensor information acquiring unit |
| 37: | frequency setting unit |
| 38: | prediction unit |
| 39: | comparison unit |
| 40: | operation receiving unit |
| 90: | computer |
| 91: | arithmetic device |
| 92: | main memory |
| 93: | auxiliary storage device |
| 94: | communication I/F |
| 95: | reading/writing device |
| 96: | input device |
| 97: | display device |
| 100: | distribution board |
| 101: | host distribution board sensor |
| 102: | subordinate distribution board sensors |
| 110: | facility equipment |
| 111: | device sensor |
| 120: | distribution board |
| 121: | distribution board sensor |
| 130: | distribution board |
| 131: | primary host distribution board sensor |
| 140: | distribution board |
| 141: | secondary host distribution board sensor |
| 142: | subordinate distribution board sensor |
| 150: | distribution board |
| 151: | distribution board sensor |
| 320: | sensor number |
| 321: | sensor type |
| 322: | lower-layer sensor number |
| 323: | acquisition frequency |
| 324: | actually measured value |
| 325: | transmitted actually measured value |
| 326: | prediction method |
| 327: | predicted value |
| 328: | prediction tolerance range |
| 329: | comparison result information |
| 330: | policy number |
| 331: | differential value |
| 332: | acquisition frequency |
| 333: | acquisition frequency |
| 334: | acquisition frequency |
| 3240: | value |

3241:     acquired time
3250:     value
3251:     transmission time
3270:     host distribution board sensor predicted value
3271:     subordinate distribution board sensor predicted value
3272:     device sensor predicted value
3273:     predicted value of distribution board sensor
3274:     predicted value of primary host distribution board sensor
3275:     predicted value of secondary host distribution board sensor
3280:     threshold lower limit
3281:     threshold upper limit
3290:     differential value
3291:     differential value

**Claims**

1. A building management device (30) to be installed in a building where a plurality of sensors are arranged, comprising:

   storage (21) configured to store, for each of the plurality of sensors, an acquisition frequency indicating how often sensor information is acquired from the each of the plurality of sensors;
   a sensor information acquiring unit (36) configured to acquire the sensor information from the each of the plurality of sensors at the acquisition frequency;
   the building management device further comprising:

   a prediction unit (38) configured to predict sensor information of one first sensor based on sensor information of a plurality of second sensors associated with the one first sensor, the one first sensor being a sensor that is high in acquisition frequency, the plurality of second sensors being sensors that are low in acquisition frequency;
   a comparison unit (39) configured to compare the sensor information of the one first sensor and the predicted sensor information; and
   a frequency setting unit (37) configured to set an acquisition frequency of at least one sensor out of the plurality of second sensors, based on a result of the comparison made by the comparison unit.

2. A building management device according to claim 1, wherein the frequency setting unit (37) is configured to set an acquisition frequency of the one first sensor based on the result of the comparison.

3. A building management device according to claim 2, wherein the frequency setting unit (37) is configured to maintain acquisition frequency settings of a third sensor, which is associated with the one first sensor and which is higher in acquisition frequency than the one first sensor.

4. A building management device according to claim 2, wherein the frequency setting unit (37) is configured to change acquisition frequency settings of a fourth sensor, which is associated with one of the plurality of second sensors and which is lower in acquisition frequency than the one of the plurality of second sensors .

5. A building management device according to claim 1, wherein the frequency setting unit (37) is configured to set an acquisition frequency of one or more sensors that are selected from the plurality of second sensors by following a given rule.

6. A building management device according to claim 1, wherein the prediction unit (38) is configured to acquire, for each of the plurality of second sensors, a predicted value based on sensor information of the each of the plurality of second sensors, and predict the sensor information of the one first sensor by adding up the plurality of predicted values acquired for the plurality of second sensors.

7. A building management device according to claim 1, wherein the prediction unit (38) is configured to predict the sensor information of the one first sensor by adding up values of pieces of sensor information of the plurality of second sensors.

8. A building management device according to claim 1, wherein the comparison unit (39) is configured to acquire a differential between the sensor information of the one first sensor and the predicted sensor information, and
wherein the frequency setting unit (37) is configured to set the acquisition frequency of at least one sensor out of the plurality of second sensors, based on the differential.

9. A building management device according to claim 8, wherein the storage (21) is configured to store each threshold range in association with the acquisition frequency, and
wherein the frequency setting unit (37) is configured to determine, as an acquisition frequency to be set to the sensor, an acquisition frequency that is associated with a threshold range in which a value indicated by the differential is included.

**10.** A building management device according to claim 9, wherein the storage (21) is configured to store the each threshold range in association with an acquisition frequency for the one first sensor and an acquisition frequency for the plurality of second sensors.

**11.** A building management device according to claim 9, wherein the storage (21) is configured to store the each threshold range that is farther from a given reference value in association with a higher acquisition frequency.

**12.** A building management device according to claim 1, wherein the plurality of sensors are configured to have a hierarchical relation, and
wherein the one first sensor is configured to be in a hierarchical layer above the plurality of second sensors.

**13.** A building management device according to claim 12 wherein the one first sensor comprises a sensor that is installed in a first distribution board included in the building,
wherein the plurality of second sensors comprise sensors that are respectively installed in a plurality of devices included in the building to which electric power is fed from the first distribution board, and
wherein the sensor information comprises information about electric power.

**14.** A building management device according to claim 12,
wherein the one first sensor comprises a sensor that is installed in a first distribution board included in the building,
wherein the plurality of second sensors comprise sensors that are respectively installed in a plurality of second distribution boards included in the building to which electric power is fed from the first distribution board, and
wherein the sensor information comprises information about electric power.

**15.** A method of acquiring data of a building management device (30) to be installed in a building where a plurality of sensors are arranged, the method comprising:

an acquiring step of acquiring sensor information from the plurality of sensors at an acquisition frequency determined for each of the plurality of sensors;
the method comprising:

a prediction step of predicting sensor information of one first sensor based on sensor information of a plurality of second sensors associated with the one first sensor, the one first sensor being a sensor that is high in acquisition frequency, the plurality of second sensors being sensors that are low in acquisition frequency;
a comparison step of comparing the sensor information of the one first sensor and the predicted sensor information; and
a frequency setting step of setting an acquisition frequency of at least one sensor out of the plurality of second sensors, based on a result of the comparison made in the comparison step.

**16.** A program executed by a building management device to be installed in a building where a plurality of sensors are arranged, the program controlling the building management device (30) to execute:

an acquiring step of acquiring sensor information from the plurality of sensors at an acquisition frequency determined for each of the plurality of sensors;
a prediction step of predicting sensor information of one first sensor based on sensor information of a plurality of second sensors associated with the one first sensor, the one first sensor being a sensor that is high in acquisition frequency, the plurality of second sensors being sensors that are low in acquisition frequency;
a comparison step of comparing the sensor information of the one first sensor and the predicted sensor information; and
a frequency setting step of setting an acquisition frequency of at least one sensor out of the plurality of second sensors, based on a result of the comparison made in the comparison step.

**17.** A wide area management system, comprising:

one or more building management devices (30) respectively installed in one or more buildings each of which has a plurality of sensors arranged therein; and
a wide area management device (20), which is connected to each of the one or more building management devices (30) via a network,
wherein the each of the one or more building management devices (30) is a building management device (30) according to claim 1, further comprising:
an information transmitting unit configured to transmit the acquired sensor information to the wide area management device;
wherein the wide area management device (20) comprises:

an information receiving unit configured to receive the sensor information from the each of the one or more building management devices (30); and

storage configured to store the received sensor information for the each of the one or more buildings.

**Patentansprüche**

1. Gebäudemanagementvorrichtung (30), die in einem Gebäude installiert werden soll, in dem mehrere Sensoren angeordnet sind, und die Folgendes umfasst:

   einen Speicher (21), der dazu konfiguriert ist, für jeden der mehreren Sensoren eine Erfassungsfrequenz zu speichern, die angibt, wie häufig Sensordaten von jedem der mehreren Sensoren erfasst werden;
   eine Sensordaten-Erfassungseinheit (36), die dazu konfiguriert ist, die Sensordaten von jedem der mehreren Sensoren mit der Erfassungsfrequenz zu erfassen;
   wobei die Gebäudemanagementvorrichtung ferner umfasst:

   eine Vorhersageeinheit (38), die konfiguriert ist, Sensordaten von einem ersten Sensor auf der Basis von Sensordaten von mehreren zweiten Sensoren, die dem einen ersten Sensor zugeordnet sind, vorherzusagen, wobei der eine erste Sensor ein Sensor ist, dessen Erfassungsfrequenz hoch ist, wobei die mehreren zweiten Sensoren Sensoren sind, deren Erfassungsfrequenz niedrig ist;
   eine Vergleichseinheit (39), die dazu konfiguriert ist, die Sensordaten des einen ersten Sensors und die vorhergesagten Sensordaten zu vergleichen; und
   eine Frequenzfestlegungseinheit (37), die dazu konfiguriert ist, eine Erfassungsfrequenz von mindestens einem Sensor aus den mehreren zweiten Sensoren auf der Basis eines Ergebnisses des durch die Vergleichseinheit durchgeführten Vergleichs festzulegen.

2. Gebäudemanagementvorrichtung nach Anspruch 1, wobei die Frequenzfestlegungseinheit (37) dazu konfiguriert ist, eine Erfassungsfrequenz des einen ersten Sensors auf der Basis des Ergebnisses des Vergleichs festzulegen.

3. Gebäudemanagementvorrichtung nach Anspruch 2, wobei die Frequenzfestlegungseinheit (37) dazu konfiguriert ist, die Erfassungsfrequenzfestlegungen eines dritten Sensors, der dem einen ersten Sensor zugeordnet ist und dessen Erfassungsfrequenz höher ist als jene des ersten Sensors, aufrechtzuerhalten.

4. Gebäudemanagementvorrichtung nach Anspruch 2, wobei die Frequenzfestlegungseinheit (37) dazu konfiguriert ist, Erfassungsfrequenzfestlegungen eines vierten Sensors zu ändern, der einem der mehreren zweiten Sensoren zugeordnet ist und dessen Erfassungsfrequenz niedriger ist als jene der mehreren zweiten Sensoren.

5. Gebäudemanagementvorrichtung nach Anspruch 1, wobei die Frequenzfestlegungseinheit (37) dazu konfiguriert ist, eine Erfassungsfrequenz von einem oder mehreren Sensoren, die aus den mehreren zweiten Sensoren ausgewählt sind, durch Befolgen einer gegebenen Regel festzulegen.

6. Gebäudemanagementvorrichtung nach Anspruch 1, wobei die Vorhersageeinheit (38) dazu konfiguriert ist, für jeden der mehreren zweiten Sensoren einen vorhergesagten Wert auf der Basis von Sensordaten von jedem der mehreren zweiten Sensoren zu erfassen und die Sensordaten des einen ersten Sensors durch Addieren der mehreren vorhergesagten Werte, die für die mehreren zweiten Sensoren erfasst werden, vorherzusagen.

7. Gebäudemanagementvorrichtung nach Anspruch 1, wobei die Vorhersageeinheit (38) dazu konfiguriert ist, die Sensordaten des einen ersten Sensors durch Addieren von Werten von Teilen von Sensordaten der mehreren zweiten Sensoren vorherzusagen.

8. Gebäudemanagementvorrichtung nach Anspruch 1, wobei die Vergleichseinheit (39) dazu konfiguriert ist, eine Differenz zwischen den Sensordaten des einen ersten Sensors und den vorhergesagten Sensordaten zu erfassen, und wobei die Frequenzfestlegungseinheit (37) dazu konfiguriert ist, die Erfassungsfrequenz von mindestens einem Sensor aus den mehreren zweiten Sensoren auf der Basis der Differenz festzulegen.

9. Gebäudemanagementvorrichtung nach Anspruch 8, wobei der Speicher (21) dazu konfiguriert ist, jeden Schwellenwertbereich in Zusammenhang mit der Erfassungsfrequenz zu speichern, und wobei die Frequenzfestlegungseinheit (37) dazu konfiguriert ist, als für den Sensor festzulegende Erfassungsfrequenz eine Erfassungsfrequenz zu bestimmen, die einem Schwellenwertbereich zugeordnet ist, in dem ein durch die Differenz angegebener Wert enthalten ist.

10. Gebäudemanagementvorrichtung nach Anspruch 9, wobei der Speicher (21) dazu konfiguriert ist, jeden Schwellenwertbereich in Zusammenhang mit einer Erfassungsfrequenz für den einen ersten Sensor und einer Erfassungsfrequenz für die mehreren zweiten Sensoren zu speichern.

11. Gebäudemanagementvorrichtung nach Anspruch 9, wobei der Speicher (21) dazu konfiguriert ist, jeden Schwellenwertbereich, der weiter von einem gegebenen Referenzwert entfernt ist, in Zusammenhang mit einer höheren Erfassungsfrequenz zu speichern.

12. Gebäudemanagementvorrichtung nach Anspruch 1, wobei die mehreren Sensoren so konfiguriert sind, dass sie eine hierarchische Beziehung aufweisen, und

wobei der eine erste Sensor so konfiguriert ist, dass er sich in einer hierarchischen Schicht über den mehreren zweiten Sensoren befindet.

13. Gebäudemanagementvorrichtung nach Anspruch 12,

wobei der eine erste Sensor einen Sensor umfasst, der in einem im Gebäude enthaltenen ersten Verteilerkasten installiert ist,

wobei die mehreren zweiten Sensoren Sensoren umfassen, die jeweils in mehreren Vorrichtungen installiert sind, die im Gebäude enthalten sind und denen elektrische Leistung vom ersten Verteilerkasten zugeführt wird, und

wobei die Sensordaten Daten über die elektrische Leistung umfassen.

14. Gebäudemanagementvorrichtung nach Anspruch 12,

wobei der eine erste Sensor einen Sensor umfasst, der in einem im Gebäude enthaltenen ersten Verteilerkasten installiert ist,

wobei die mehreren zweiten Sensoren Sensoren umfassen, die jeweils in mehreren zweiten Verteilerkästen installiert sind, die im Gebäude enthalten sind, denen elektrische Leistung vom ersten Verteilerkasten zugeführt wird, und

wobei die Sensordaten Daten über die elektrische Leistung umfassen.

15. Verfahren zum Erfassen von Daten einer Gebäudemanagementvorrichtung (30), die in einem Gebäude installiert werden soll, in dem mehrere Sensoren angeordnet sind, wobei das Verfahren umfasst:

einen Erfassungsschritt zum Erfassen von Sensordaten von den mehreren Sensoren mit einer Erfassungsfrequenz, die für jeden der mehreren Sensoren bestimmt ist;
wobei das Verfahren umfasst:

einen Vorhersageschritt zum Vorhersagen von Sensordaten von einem ersten Sensor auf der Basis von Sensordaten von mehreren zweiten Sensoren, die dem einen ersten Sensor zugeordnet sind, wobei der eine erste Sensor ein Sensor ist, dessen Erfassungsfrequenz hoch ist, wobei die mehreren zweiten Sensoren Sensoren sind, deren Erfassungsfrequenz niedrig ist;
einen Vergleichsschritt zum Vergleichen der Sensordaten des einen ersten Sensors und der vorhergesagten Sensordaten; und
einen Frequenzfestlegungsschritt zum Festlegen einer Erfassungsfrequenz von mindestens einem Sensor aus den mehreren zweiten Sensoren auf der Basis eines Ergebnisses des im Vergleichsschritt durchgeführten Vergleichs.

16. Programm, das durch eine Gebäudemanagementvorrichtung ausgeführt wird, die in einem Gebäude installiert werden soll, in dem mehrere Sensoren angeordnet sind, wobei das Programm die Gebäudemanagementvorrichtung (30) steuert, um Folgendes auszuführen:

einen Erfassungsschritt zum Erfassen von Sensordaten von den mehreren Sensoren mit einer Erfassungsfrequenz, die für jeden der mehreren Sensoren bestimmt ist;
einen Vorhersageschritt zum Vorhersagen von Sensordaten von einem ersten Sensor auf der Basis von Sensordaten von mehreren zweiten Sensoren, die dem einen ersten Sensor zugeordnet sind, wobei der eine erste Sensor ein Sensor ist, dessen Erfassungsfrequenz hoch ist, wobei die mehreren zweiten Sensoren Sensoren sind, deren Erfassungsfrequenz niedrig ist;
einen Vergleichsschritt zum Vergleichen der Sensordaten des einen ersten Sensors und der vorhergesagten Sensordaten; und
einen Frequenzfestlegungsschritt zum Festlegen einer Erfassungsfrequenz von mindestens einem Sensor aus den mehreren zweiten Sensoren auf der Basis eines Ergebnisses des im Vergleichsschritt durchgeführten Vergleichs.

17. Großraummanagementsystem, das Folgendes umfasst:

eine oder mehrere Gebäudemanagementvorrichtungen (30), die jeweils in einem oder mehreren Gebäuden installiert sind, wovon jedes mehrere Sensoren aufweist, die darin angeordnet sind; und
eine Großraummanagementvorrichtung (20), die mit jeder der einen oder mehreren Gebäudemanagementvorrichtungen (30) über ein Netz verbunden ist,

wobei jede der einen oder der mehreren Gebäudemanagementvorrichtungen (30) eine Gebäudemanagementvorrichtung (30) nach Anspruch 1 ist, die ferner umfasst:

eine Datenübertragungseinheit, die dazu konfiguriert ist, die erfassten Sensordaten zur Großraummanagementvorrichtung zu übertragen;
wobei die Großraummanagementvorrichtung (20) umfasst:

eine Datenempfangseinheit, die dazu konfiguriert ist, die Sensordaten von jeder der einen oder der mehreren Gebäudemanagementvorrichtungen (30) zu empfangen; und
einen Speicher, der dazu konfiguriert ist, die empfangenen Sensordaten für jedes des einen oder der mehreren Gebäude zu speichern.

## Revendications

1. Dispositif de gestion de bâtiment (30) destiné à être installé dans un bâtiment où une pluralité de capteurs sont disposés, comprenant :

une mémoire (21) configurée pour stocker, pour chacun de la pluralité de capteurs, une fréquence d'acquisition indiquant à quelle fréquence des informations de capteur sont acquises à partir de chacun de la pluralité de capteurs ;
une unité d'acquisition d'informations de capteur (36) configurée pour acquérir les informations de capteur à partir de chacun de la pluralité de capteurs à la fréquence d'acquisition ;
le dispositif de gestion de bâtiment comprenant en outre :

une unité de prédiction (38) configurée pour prédire des informations de capteur d'un premier capteur sur la base des informations de capteur d'une pluralité de deuxièmes capteurs associés au premier capteur, le premier capteur étant un capteur dont la fréquence d'acquisition est élevée, la pluralité de deuxièmes capteurs étant des capteurs dont la fréquence d'acquisition est basse ;
une unité de comparaison (39) configurée pour comparer les informations de capteur du premier capteur et les informations de capteur prédites ; et
une unité de réglage de fréquence (37) configurée pour régler une fréquence d'acquisition d'au moins un capteur parmi la pluralité de deuxièmes capteurs sur la base du résultat de la comparaison effectuée par l'unité de comparaison.

2. Dispositif de gestion de bâtiment selon la revendication 1, dans lequel l'unité de réglage de fréquence (37) est configurée pour régler une fréquence d'acquisition du premier capteur sur la base du résultat de la comparaison.

3. Dispositif de gestion de bâtiment selon la revendication 2, dans lequel l'unité de réglage de fréquence (37) est configurée pour maintenir les réglages de fréquence d'acquisition d'un troisième capteur qui est associé au premier capteur et dont la fréquence d'acquisition est plus élevée que celle du premier capteur.

4. Dispositif de gestion de bâtiment selon la revendication 2, dans lequel l'unité de réglage de fréquence (37) est configurée pour modifier les réglages de fréquence d'acquisition d'un quatrième capteur qui est associé à l'un de la pluralité de deuxièmes capteurs et dont la fréquence d'acquisition est plus basse que celle de la pluralité de deuxièmes capteurs.

5. Dispositif de gestion de bâtiment selon la revendication 1, dans lequel l'unité de réglage de fréquence (37) est configurée pour régler une fréquence d'acquisition d'un ou plusieurs capteurs qui sont sélectionnés parmi la pluralité de deuxièmes capteurs en suivant une règle donnée.

6. Dispositif de gestion de bâtiment selon la revendication 1, dans lequel l'unité de prédiction (38) est configurée pour acquérir, pour chacun de la pluralité de deuxièmes capteurs, une valeur prédite sur la base des informations de capteur de chacun de la pluralité de deuxièmes capteurs et prédire les informations de capteur du premier capteur en additionnant la pluralité de valeurs prédites acquises pour la pluralité de deuxièmes capteurs.

7. Dispositif de gestion de bâtiment selon la revendication 1, dans lequel l'unité de prédiction (38) est configurée pour prédire les informations de capteur du premier capteur en additionnant des valeurs d'informations de capteur de la pluralité de deuxièmes capteurs.

8. Dispositif de gestion de bâtiment selon la revendication 1,
dans lequel l'unité de comparaison (39) est configurée pour acquérir un différentiel entre les informations de capteur du premier capteur et les informations de capteur prédites, et
dans lequel l'unité de réglage de fréquence (37) est configurée pour régler la fréquence d'acquisition d'au moins un capteur parmi la pluralité de deuxièmes capteurs sur la base du différentiel.

9. Dispositif de gestion de bâtiment selon la revendication 8,
dans lequel la mémoire (21) est configurée pour stocker chaque plage de seuil en association avec la fréquence d'acquisition et
dans lequel l'unité de réglage de fréquence (37) est configurée pour déterminer, en tant que fréquence d'acquisition à régler pour le capteur, une fréquence d'acquisition qui est associée à une plage de seuil dans laquelle une valeur indiquée par le différentiel est incluse.

10. Dispositif de gestion de bâtiment selon la revendication 9, dans lequel la mémoire (21) est configurée pour stocker chaque plage de chaque seuil en association avec une fréquence d'acquisition pour le premier capteur et une fréquence d'acquisition pour la pluralité de deuxièmes capteurs.

11. Dispositif de gestion de bâtiment selon la revendication 9, dans lequel la mémoire (21) est configurée pour stocker chaque plage de seuil qui est plus éloignée d'une valeur de référence donnée en association avec une fréquence d'acquisition plus élevée.

12. Dispositif de gestion de bâtiment selon la revendication 1,
dans lequel la pluralité de capteurs sont configurés pour avoir une relation hiérarchique et
dans lequel le premier capteur est configuré pour être dans une couche hiérarchique supérieure à la pluralité de deuxièmes capteurs.

13. Dispositif de gestion de bâtiment selon la revendication 12,
dans lequel le premier capteur comprend un capteur qui est installé dans un premier tableau de distribution inclus dans le bâtiment,
dans lequel la pluralité de deuxièmes capteurs comprennent des capteurs qui sont respectivement installés dans une pluralité de dispositifs inclus dans le bâtiment auxquels de l'énergie électrique est fournie par le premier tableau de distribution et
dans lequel les informations de capteur comprennent des informations concernant l'énergie électrique.

14. Dispositif de gestion de bâtiment selon la revendication 12,
dans lequel le premier capteur comprend un capteur qui est installé dans un premier tableau de distribution inclus dans le bâtiment,
dans lequel la pluralité de deuxièmes capteurs comprend des capteurs qui sont respectivement installés dans une pluralité de deuxièmes tableaux de distribution inclus dans le bâtiment auxquels de l'énergie électrique est fournie par le premier tableau de distribution et
dans lequel les informations de capteur comprennent des informations concernant l'énergie électrique.

15. Procédé d'acquisition de données d'un dispositif de gestion de bâtiment (30) destiné à être installé dans un bâtiment où une pluralité de capteurs sont disposés, le procédé comprenant :

une étape d'acquisition consistant à acquérir des informations de capteur à partir de la pluralité de capteurs à une fréquence d'acquisition déterminée pour chacun de la pluralité de capteurs ;
le procédé comprenant :

une étape de prédiction consistant à prédire des informations de capteur d'un premier capteur sur la base des informations de capteur d'une pluralité de deuxièmes capteurs associés au premier capteur, le premier capteur étant un capteur dont la fréquence d'acquisition est élevée, la pluralité de deuxièmes capteurs étant des capteurs dont la fréquence d'acquisition est basse ;
une étape de comparaison consistant à comparer les informations de capteur du premier capteur et les informations de capteur prédites ; et
une étape de réglage de fréquence consistant à régler une fréquence d'acquisition d'au moins un capteur parmi la pluralité de deuxièmes capteurs sur la base du résultat de la comparaison effectuée dans l'étape de comparaison.

16. Programme exécuté par un dispositif de gestion de bâtiment destiné à être installé dans un bâtiment où une pluralité de capteurs sont disposés, le programme commandant le dispositif de gestion de bâtiment (30) pour exécuter :

une étape d'acquisition consistant à acquérir des informations de capteur à partir de la pluralité de capteurs à une fréquence d'acquisition déterminée pour chacun de la pluralité de capteurs ;
une étape de prédiction consistant à prédire des informations de capteur d'un premier capteur sur la base des informations de capteur d'une pluralité de deuxièmes capteurs associés au premier capteur, le premier capteur étant un capteur dont la fréquence d'acquisition est élevée, la pluralité de deuxièmes capteurs étant des capteurs dont la fréquence d'acquisition est basse ;

une étape de comparaison consistant à comparer les informations de capteur du premier capteur et les informations de capteur prédites ; et

une étape de réglage de fréquence consistant à régler une fréquence d'acquisition d'au moins un capteur parmi la pluralité de deuxièmes capteurs sur la base du résultat de la comparaison effectuée dans l'étape de comparaison.

17. Système de gestion de zone étendue, comprenant :

un ou plusieurs dispositifs de gestion de bâtiment (30) respectivement installés dans un ou plusieurs bâtiments à l'intérieur de chacun desquels une pluralité de capteurs sont disposés ; et

un dispositif de gestion de zone étendue (20) qui est connecté à chacun desdits un ou plusieurs dispositifs de gestion de bâtiment (30) par l'intermédiaire d'un réseau,

dans lequel chacun desdits un ou plusieurs dispositifs de gestion de bâtiment (30) est un dispositif de gestion de bâtiment (30) selon la revendication 1, comprenant en outre :

une unité de transmission d'informations configurée pour transmettre les informations de capteur acquises au dispositif de gestion de zone étendue ;

dans lequel le dispositif de gestion de zone étendue (20) comprend :

une unité de réception d'informations configurée pour recevoir les informations de capteur provenant de chacun desdits un ou plusieurs dispositifs de gestion de bâtiment (30) ; et

une mémoire configurée pour stocker les informations de capteur reçues pour chacun desdits un ou plusieurs bâtiments.

# Fig 1

WIDE AREA MANAGEMENT SYSTEM 10

# Fig 2

WHEN ACQUISITION FREQUENCY IS HIGH

# Fig 3

WHEN ACQUISITION FREQUENCY IS LOW

# Fig 4

# Fig 5

BUILDING MANAGEMENT DEVICE — 30 / 31

34 — INFORMATION RECEIVING UNIT

35 — INFORMATION TRANSMITTING UNIT

36 — SENSOR INFORMATION ACQUIRING UNIT

37 — FREQUENCY SETTING UNIT

38 — PREDICTION UNIT

39 — COMPARISON UNIT

40 — OPERATION RECEIVING UNIT

STORAGE

32 — BUILDING MANAGEMENT TABLE

33 — ACQUISITION FREQUENCY DETERMINING POLICY

# Fig 6

BUILDING MANAGEMENT TABLE 32

| SENSOR NUMBER (Sn) 320 | SENSOR TYPE 321 | LOWER-LAYER SENSOR NUMBER (Sn) 322 | ACQUISITION FREQUENCY (sec) 323 | ACTUALLY MEASURED VALUE (S'n) 324 | | TRANSMITTED ACTUALLY MEASURED VALUE 325 | | PREDICTION METHOD 326 | PREDICTED VALUE (S"n) 327 | | | PREDICTION TOLERANCE RANGE 328 | | COMPARISON RESULT INFORMATION 329 | |
|---|---|---|---|---|---|---|---|---|---|---|---|---|---|---|---|
| | | | | VALUE (W) 3240 | ACQUIRED TIME 3241 | VALUE (W) 3250 | TRANS-MISSION TIME 3251 | | HOST DISTRIBU-TION BOARD SENSOR (W) 3270 | SUBORDINATE DISTRIBUTION BOARD SENSOR(W) 3271 | DEVICE SENSOR (W) 3272 | THRESHOLD LOWER LIMIT(W) 3280 | THRESHOLD UPPER LIMIT(W) 3281 | DIFFERENCE BETWEEN ACTUALLY MEASURED VALUE AND PREDICTED VALUE(W) 3290 | DIFFERENCE BETWEEN ACTUALLY MEASURED VALUE AND PREDICTED VALUE (%) 3291 |
| 1 | HOST DISTRIBU-TION BOARD SENSOR | 2,3 | 10 | 1600 | 2014/2/27 10:00:50 | 1500 | 2014/2/27 10:00:00 | | 1500 | | | -60 | +60 | -100 | -6.25 |
| 2 | SUBORDI-NATE DISTRIBU-TION BOARD SENSOR | 4,5,6 | 20 | 700 | 2014/2/27 10:00:20 | 700 | 2014/2/27 10:00:20 | | | 700 | | -30 | +30 | 0 | 0 |
| 3 | SUBORDI-NATE DISTRIBU-TION BOARD SENSOR | 7,8,9 | 20 | 800 | 2014/2/27 10:00:40 | 800 | 2014/2/27 10:00:40 | | | 800 | | -30 | +30 | 0 | 0 |
| 4 | DEVICE SENSOR | | 300 | 200 | 2014/2/27 09:59:00 | 200 | 2014/2/27 09:59:00 | LINEAR PREDICTION | | | 210 | -10 | +10 | +10 | 1.05 |
| ⋮ | ⋮ | ⋮ | ⋮ | ⋮ | ⋮ | ⋮ | ⋮ | ⋮ | ⋮ | ⋮ | ⋮ | ⋮ | ⋮ | ⋮ | ⋮ |

EP 3 163 897 B1

# Fig 7

BUILDING MANAGEMENT TABLE32

| SENSOR NUMBER (Sn) | SENSOR TYPE | LOWER-LAYER SENSOR NUMBER (Sn) | ACQUISITION FREQUENCY(sec) | ACTUALLY MEASURED VALUE (S'n) | | TRANSMITTED ACTUALLY MEASURED VALUE | | PREDICTION METHOD | PREDICTED VALUE (S"n) | | | PREDICTION TOLERANCE RANGE | | COMPARISON RESULT INFORMATION | |
|---|---|---|---|---|---|---|---|---|---|---|---|---|---|---|---|
| | | | | VALUE (W) | ACQUIRED TIME | VALUE (W) | TRANS-MISSION TIME | | HOST DISTRIBUTION BOARD SENSOR (W) | SUBORDINATE DISTRIBUTION BOARD SENSOR (W) | DEVICE SENSOR(W) | THRESHOLD LOWER LIMIT (W) | THRESHOLD UPPER LIMIT (W) | DIFFERENCE BETWEEN ACTUALLY MEASURED VALUE AND PREDICTED VALUE(W) | DIFFERENCE BETWEEN ACTUALLY MEASURED VALUE AND PREDICTED VALUE(%) |
| ⋮ | ⋮ | ⋮ | ⋮ | ⋮ | ⋮ | ⋮ | ⋮ | ⋮ | ⋮ | ⋮ | ⋮ | ⋮ | ⋮ | ⋮ | ⋮ |
| 3 | SUBORDI-NATE DISTRIBU-TION BOARD SENSOR | 7,8,9 | 20 | 820 | 2014/2/27 10:00:00 | 800 | 2014/2/27 10:00:00 | | | 840 | | -30 | +30 | +20 | 1.02 |
| ⋮ | ⋮ | ⋮ | ⋮ | ⋮ | ⋮ | ⋮ | ⋮ | ⋮ | ⋮ | ⋮ | ⋮ | ⋮ | ⋮ | ⋮ | ⋮ |
| 7 | DEVICE SENSOR | | 300 | 200 | 2014/2/27 09:59:00 | 200 | 2014/2/27 09:59:00 | LINEAR PREDICTION | | | 210 | -10 | +10 | +10 | 1.05 |
| 8 | DEVICE SENSOR | | 300 | 300 | 2014/2/27 09:59:20 | 300 | 2014/2/27 09:59:20 | LINEAR PREDICTION | | | 320 | -10 | +10 | +20 | 1.07 |
| 9 | DEVICE SENSOR | | 300 | 300 | 2014/2/27 09:59:40 | 300 | 2014/2/27 09:59:40 | LINEAR PREDICTION | | | 310 | -10 | +10 | +10 | 1.03 |

Reference numbers: 320, 321, 322, 323, 324 (3240, 3241), 325 (3250, 3251), 326, 327 (3270, 3271, 3272), 328 (3280, 3281), 329 (3290, 3291)

EP 3 163 897 B1

# Fig 8

## ACQUISITION FREQUENCY DETERMINING POLICY 33

| 330 | 331 | 332 | 333 | 334 |
|---|---|---|---|---|
| POLICY NUMBER | DIFFERENCE BETWEEN ACTUALLY MEASURED VALUE AND PREDICTED VALUE (%) | HOST DISTRIBUTION BOARD SENSOR ACQUISITION FREQUENCY (sec) | SUBORDINATE DISTRIBUTION BOARD SENSOR ACQUISITION FREQUENCY(sec) | DEVICE SENSOR ACQUISITION FREQUENCY (sec) |
| 1 | 0 ~ ±5 | 10 | 20 | 200 |
| 2 | +5 ~ +10<br>-5 ~ -10 | 5 | 10 | 100 |
| 3 | +10 ~ +15<br>-10 ~ -15 | 1 | 5 | 50 |
| ⋮ | ⋮ | ⋮ | ⋮ | ⋮ |

# Fig 9

```
┌─────────────────────────────────────────┐
│   ┌───────────────────────────────┐      │
│   │            START              │      │
│   └───────────────────────────────┘      │
│                  │                        │
│                  ▼                        │
│   ┌───────────────────────────────┐   ⌇ S1│
│   │      SENSOR INFORMATION       │      │
│   │     ACQUIRING PROCESSING      │      │
│   └───────────────────────────────┘      │
│                  │                        │
│                  ▼                        │
│   ┌───────────────────────────────┐   ⌇ S2│
│   │   COMPARISON PROCESSING       │      │
│   │   ┌───────────────────────┐   │      │
│   │   │     PREDICTION        │   │      │
│   │   │     PROCESSING        │   │      │
│   │   └───────────────────────┘   │      │
│   └───────────────────────────────┘      │
│                  │                        │
│                  ▼                        │
│   ┌───────────────────────────────┐   ⌇ S3│
│   │   ACQUISITION FREQUENCY       │      │
│   │   DETERMINING PROCESSING      │      │
│   └───────────────────────────────┘      │
│                  │                        │
│                  ▼                        │
│   ┌───────────────────────────────┐      │
│   │             END               │      │
│   └───────────────────────────────┘      │
└─────────────────────────────────────────┘
```

# Fig 10

```
          ┌─────────────────────────────┐
          │            START            │
          └─────────────────────────────┘
                         │
                         ▼
          ┌─────────────────────────────┐
          │ BASED ON ACQUISITION         │   S100
          │ FREQUENCY, DETERMINE         │
          │ SENSOR Sn OF WHICH ACTUALLY  │
          │ MEASURED VALUE IS ACQUIRED   │
          └─────────────────────────────┘
                         │
                         ▼
          ┌─────────────────────────────┐
          │ TRANSMIT COMMAND FOR         │   S105
          │ ACQUIRING ACTUALLY           │
          │ MEASURED VALUE (S'n) TO      │
          │ SENSOR Sn                    │
          └─────────────────────────────┘
                         │
                         ▼
          ┌─────────────────────────────┐
          │ RECEIVE ACTUALLY MEASURED    │   S110
          │ VALUE (S'n) FROM SENSOR Sn   │
          └─────────────────────────────┘
                         │
                         ▼
          ┌─────────────────────────────┐
          │ RECORD ACTUALLY MEASURED     │   S115
          │ VALUE (S'n)                  │
          └─────────────────────────────┘
                         │
                         ▼
          ┌─────────────────────────────┐
          │            END              │
          └─────────────────────────────┘
```

# Fig 11

START — S200

ACQUIRE ACTUALLY MEASURED VALUE (S'n) — S205

IS SENSOR Sn DEVICE SENSOR?

NO (DISTRIBUTION BOARD SENSOR)

YES

IS SENSOR Sn SUBORDINATE DISTRIBUTION BOARD SENSOR? — S215

NO (HOST DISTRIBUTION BOARD SENSOR (PRIMARY TO N-TH ORDER))

YES

**ROUTE 1** — S210

<PREDICTION PROCESSING>
CALCULATE PREDICTED VALUE (S"n) OF SENSOR Sn BY PREDICTION METHOD

**ROUTE 2** — S220

<PREDICTION PROCESSING>
CALCULATE PREDICTED VALUE FOR EACH DEVICE SENSOR BELOW, AND USE SUM OF CALCULATED PREDICTED VALUES AS PREDICTED VALUE (S"n) OF SENSOR Sn

**ROUTE 3** — S225

<PREDICTION PROCESSING>
CALCULATE PREDICTED VALUE FOR EACH DISTRIBUTION BOARD SENSOR BELOW, AND USE SUM OF CALCULATED PREDICTED VALUES AS PREDICTED VALUE (S"n) OF SENSOR Sn

RECORD PREDICTED VALUE (S"n) — S230

<COMPARISON PROCESSING>
IS DIFFERENCE BETWEEN ACTUALLY MEASURED VALUE (S'n) AND PREDICTED VALUE (S"n) WITHIN PREDICTION TOLERANCE RANGE? — S235

NO

TRANSMIT ACTUALLY MEASURED VALUE (S'n) TO WIDE AREA MANAGEMENT DEVICE — S240

YES

RECORD COMPARISON RESULT INFORMATION — S245

END

EP 3 163 897 B1

# Fig 12

START

S300

IS SENSOR Sn DEVICE SENSOR? — NO (DISTRIBUTION BOARD SENSOR)

YES

ROUTE 1

S310

IS SENSOR Sn SUBORDINATE DISTRIBUTION BOARD SENSOR? — NO (PRIMARY TO N-TH ORDER))

(HOST DISTRIBUTION BOARD SENSOR

ROUTE 2 ↓ YES

ROUTE 3 ↓

S315

SELECT ONE OR MORE DEVICE SENSORS FOR WHICH ACQUISITION FREQUENCY IS CHANGED BY FOLLOWING SENSOR SELECTING POLICY

S325

SELECT ONE OR MORE DISTRIBUTION BOARD SENSORS FOR WHICH ACQUISITION FREQUENCY IS CHANGED BY FOLLOWING SENSOR SELECTING POLICY

S305

DETERMINE ACQUISITION FREQUENCY OF DEVICE SENSOR Sn BY FOLLOWING ACQUISITION FREQUENCY POLICY

DETERMINE ACQUISITION FREQUENCY OF SELECTED DEVICE SENSOR GROUP BY FOLLOWING ACQUISITION FREQUENCY POLICY

S330

DETERMINE ACQUISITION FREQUENCY OF SELECTED DISTRIBUTION BOARD SENSOR GROUP BY FOLLOWING ACQUISITION FREQUENCY POLICY

S320

S335

RECORD DETERMINED ACQUISITION FREQUENCY

END

EP 3 163 897 B1

# Fig 13

# Fig 14

BUILDING MANAGEMENT TABLE 32

| SENSOR NUMBER (Sn) 320 | SENSOR TYPE 321 | LOWER-LAYER SENSOR NUMBER (Sn) 322 | ACQUISITION FREQUENCY (sec) 323 | ACTUALLY MEASURED VALUE (S'n) | | TRANSMITTED ACTUALLY MEASURED VALUE | | PREDICTION METHOD 326 | PREDICTED VALUE(S"n) | | PREDICTION TOLERANCE RANGE | | COMPARISON RESULT INFORMATION | |
|---|---|---|---|---|---|---|---|---|---|---|---|---|---|---|
| | | | | VALUE (W) 3240 | ACQUIRED TIME 3241 | VALUE (W) 3250 | TRANS-MISSION TIME 3251 | | DISTRIBU-TION BOARD SENSOR (W) 3273 | DEVICE SENSOR (W) 3272 | THRESHOLD LOWER LIMIT(W) 3280 | THRESHOLD UPPER LIMIT(W) 3281 | DIFFERENCE BETWEEN ACTUALLY MEASURED VALUE AND PREDICTED VALUE (W) 3290 | DIFFERENCE BETWEEN ACTUALLY MEASURED VALUE AND PREDICTED VALUE(%) 3291 |
| 1 | DISTRIBU-TION BOARD SENSOR | 2,3,4,5,6,7 | 10 | 1500 | 2014/2/27 10:00:50 | 1500 | 2014/2/27 10:00:00 | | 1500 | | -60 | +60 | 0 | 0 |
| 2 | DEVICE SENSOR | | 200 | 300 | 2014/2/27 09:59:00 | 300 | 2014/2/27 09:59:00 | LINEAR PREDICTION | | 300 | -10 | +10 | 0 | 0 |
| 3 | DEVICE SENSOR | | 200 | 200 | 2014/2/27 09:59:20 | 200 | 2014/2/27 10:00:20 | LINEAR PREDICTION | | 200 | -10 | +10 | 0 | 0 |
| 4 | DEVICE SENSOR | | 200 | 200 | 2014/2/27 09:59:40 | 200 | 2014/2/27 09:59:40 | LINEAR PREDICTION | | 200 | -10 | +10 | 0 | 0 |
| ⋮ | ⋮ | ⋮ | ⋮ | ⋮ | ⋮ | ⋮ | ⋮ | ⋮ | ⋮ | ⋮ | ⋮ | ⋮ | ⋮ | ⋮ |

EP 3 163 897 B1

# Fig 15

# Fig 16

BUILDING MANAGEMENT TABLE 32

| SENSOR NUMBER (Sn) | SENSOR TYPE | LOWER-LAYER SENSOR NUMBER (Sn) | ACQUISITION FREQUENCY (sec) | ACTUALLY MEASURED VALUE (S'n) VALUE (W) | ACTUALLY MEASURED VALUE (S'n) ACQUIRED TIME | TRANSMITTED ACTUALLY MEASURED VALUE VALUE (W) | TRANSMITTED ACTUALLY MEASURED VALUE TRANS-MISSION TIME | PREDICTION METHOD | PREDICTED VALUE (S"n) PRIMARY HOST DISTRIBUTION BOARD SENSOR(W) | PREDICTED VALUE (S"n) SECONDARY HOST DISTRIBUTION BOARD SENSOR(W) | PREDICTED VALUE (S"n) SUBORDINATE DISTRIBUTION BOARD SENSOR(W) | PREDICTED VALUE (S"n) DEVICE SENSOR (W) | PREDICTION TOLERANCE RANGE THRESHOLD LOWER LIMIT(W) | PREDICTION TOLERANCE RANGE THRESHOLD UPPER LIMIT (W) | COMPARISON RESULT INFORMATION DIFFERENCE BETWEEN ACTUALLY MEASURED VALUE AND PREDICTED VALUE (W) | COMPARISON RESULT INFORMATION DIFFERENCE BETWEEN ACTUALLY MEASURED VALUE AND PREDICTED VALUE(%) |
|---|---|---|---|---|---|---|---|---|---|---|---|---|---|---|---|---|
| 1 | PRIMARY HOST DISTRIBUTION BOARD SENSOR | 2,3 | 10 | 3000 | 2014/2/27 10:00:50 | 3000 | 2014/2/27 10:00:00 | | 3000 | | | | -100 | ÷100 | 0 | 0 |
| 2 | SECONDARY HOST DISTRIBUTION BOARD SENSOR | 4,5 | 20 | 1500 | 2014/2/27 10:00:10 | 1500 | 2014/2/27 10:00:10 | | | 1500 | | | -50 | ÷50 | 0 | 0 |
| 3 | SUBORDINATE DISTRIBUTION BOARD SENSOR | 12,13, 14,15, 16,17 | 50 | 1500 | 2014/2/27 10:00:20 | 1500 | 2014/2/27 10:00:20 | | | | 1500 | | -30 | ÷30 | 0 | 0 |
| 4 | SUBORDINATE DISTRIBUTION BOARD SENSOR | 6,7,8 | 50 | 700 | 2014/2/27 10:00:30 | 700 | 2014/2/27 10:00:30 | | | | 700 | | -10 | +10 | 0 | 0 |
| ⋮ | ⋮ | ⋮ | ⋮ | ⋮ | ⋮ | ⋮ | ⋮ | ⋮ | ⋮ | ⋮ | ⋮ | ⋮ | ⋮ | ⋮ | ⋮ | ⋮ |

Reference labels: 320, 321, 322, 323, 3240, 324, 3241, 3250, 325, 3251, 326, 3274, 327, 3275, 3271, 3272, 3280, 328, 3281, 3290, 329, 3291

EP 3 163 897 B1

# Fig 17

90

COMPUTER

91
ARITHMETIC
DEVICE

92
MAIN
MEMORY

93
AUXILIARY
STORAGE
DEVICE

94
COMMUNI
-CATION I/F

95
READING/
WRITING
DEVICE

96
INPUT
DEVICE

97
DISPLAY
DEVICE

**REFERENCES CITED IN THE DESCRIPTION**

**Patent documents cited in the description**

- JP 2012199726 A
- US 2014139188 A1

- JP 2013162589 A